# EUROPEAN PATENT SPECIFICATION

(11) **EP 3 137 430 B1**
(45) Date of publication and mention of the grant of the patent: **06.06.2018**
(21) Application number: 15700121.5
(22) Date of filing: 09.01.2015
(51) Int. Cl.: C03C 17/00, C03C 17/245, C03C 17/36, C23C 14/00

(54) **TEMPERATURE RESISTANT COATING SYSTEM WITH TIOX LAYER ON A TRANSPARENT SUBSTRATE**
TEMPERATURBESTAENDIGES BESCHICHTUNGSSYSTEM MIT TIOX AUF EINEM TRANSPARENTEN SUBSTRAT
SYSTEME DE REVETEMENT RESISTANT A LA TEMPERATURE COMPRENANT DU TIOX

(30) Priority: 09.01.2014 EP 14150609
(43) Date of publication of application: 08.03.2017
(73) Proprietor: INTERPANE Entwicklungs-und Beratungsgesellschaft mbH, 37697 Lauenförde (DE)
(72) Inventor: WAGNER, Dominik, 37671 Lüchtringen (DE); WEIS, Hansjörg, 37671 Höxter (DE); PURWINS, Michael, 37170 Uslar (Offensen) (DE); KAPPERTZ, Oliver, 37077 Göttingen (DE); MÄDER, Sebastian, 52064 Aachen (DE); WUTTIG, Matthias, 52074 Aachen (DE); SCHMIDT, Rüdiger M., 28213 Bremen (DE)
(74) Representative: Körfer, Thomas
(86) International application number: PCT/EP2015/050314
(87) International publication number: WO 2015/104365

(56) References cited:
- EP-A1- 1 666 428
- WO-A1-2012/165501
- WO-A2-2012/041499
- DE-A1-102010 008 115
- DE-B3- 10 333 619
- DE-B4-102005 038 139
- US-A1- 2003 000 828
- US-A1- 2006 051 597
- US-A1- 2010 233 473

## Description

The present invention relates to a transparent substrate, such as glass, which is coated with a coating system, and further relates to methods of coating the substrate with the coating system.

A coating for a transparent structure such as glass window, for example, may comprise a thin-film multilayer coating or 'coating system' including at least one functional layer for implementing a desired function or property of the structure or substrate such as, for example, a low emissivity ('low-E') property which is intended to reduce an amount of energy dissipated to the outside via windows in buildings. In said example, the functional layer may be supposed to act on solar radiation and/or infrared radiation. With regard to said radiation, the functional layer may implement desired reflective properties. A functional layer of this type may comprise, e.g., a metallic material such as silver or copper.

The coating system may comprise further layers to implement auxiliary functions. For example, a seed layer may be provided to facilitate growing of the functional (metallic) layer on the substrate. Further layers may be provided to preserve the integrity or prevent the impairment of the functional layer during product manufacturing subsequent to the coating and/or when the coated substrate is in use. For example, one or more blocker layers may be provided to prevent oxygen diffusion into the functional layer(s) from the ambient atmosphere and/or the glass substrate, as may occur for example at high temperatures during tempering processes.

Dielectric layers may be provided below and/or above a functional layer and may serve, for example, for adding desired antireflection properties. A sticking layer may be provided to optimize a sticking or bonding of the coating system to the substrate, a top covering layer may be provided for mechanical protection of the functional layer and/or the substrate, etc.

The coated substrate may undergo further manufacturing steps which may in particular comprise one or more tempering steps. For instance, a tempering process may comprise heating the substrate to temperatures of about 300°C (degree Celsius) for timescales of hours for outgassing, passivation, etc. Other tempering processes may comprise heating the substrate to temperatures of about 580°C, or even to temperatures of about 650°C, for timescales of minutes for, e.g., pre-stressing or hardening the glass, wherein exemplary resulting products may include safety glass for use in vehicles or architectural glass.

For economic and/or manufacturing reasons, it may be desirable to apply the coating system to the substrate prior to the or any tempering process. Therefore the coating system has to withstand the tempering process, i.e. adverse effects of the tempering on desired product properties, in particular optical properties, have to be minimized.

The tempering problem is known to be relevant in particular for coating layers comprising titanium oxide (TiOₓ). Tempering may lead to local variances in TiOₓ layer properties which may result for example in unwanted haze, i.e.an undesirably high degree of diffuse reflection.

More specifically, titanium oxide when involved in a tempering process can be impaired (deteriorated) in terms of optical properties of the layer which may result in the coated product being impaired in terms of transparency, brilliancy, etc. It is generally assumed that due to the high temperatures applied during a tempering process a structure of the TiOₓ layer may undergo changes. For example, in case of an initially amorphous layer (no crystalline structure prior to tempering), high temperatures may lead the titanium oxide to adopt at least in part or portion-wise a crystal structure such as an anatase structure, rutile structure, a mixture of both, etc. However, the amorphous and the various crystalline structures differ in their volume filling factors; for example, even the unit cells of the various crystalline structures differ from each other. Corresponding internal stresses (tensioning) may result in crack formation which contributes to impairment of optical properties. Fractures in the TiOₓ layer may also result in loss of oxidation protection and/or may attract moisture with further temporary or permanent impairment of optical properties.

DE 10 2005 038 139 A1 describes a thermal stress resistant, low emission laminate system for coating transparent substrates, which comprises an antireflective oxide layer, a zinc oxide layer, a silver layer, a blocking layer of titanium alloy, an antireflective layer and a covering layer, wherein the blocking layer is a metallic or weakly nitrided layer of titanium alloy containing 50-97 at.-% titanium and 3-50 at.-% chromium, iron, zirconium and/or hafnium.

The document WO 2012/165501 A1 describes a low-E laminated glass comprising a TiO2 layer, which can be doped with Nb, Ta, Zr, Si, W or Mo.

The document EP 1666 428 A1 describes coatings based on TiO2, which might be doped with Si, Nb, Zr, or Ta. One object of the invention is a cost-efficient approach of minimizing adverse effects of tempering on a coating system including a titanium oxide TiOₓ layer as a dielectric layer.

The above object is solved by a substrate with a coating system according to claim 1, a method of manufacturing such substrate according to claim 9 and a method of analyzing such substrate according to claim 12.

According to one aspect of the invention, a transparent substrate coated with a temperature resistant coating system is proposed. The transparent substrate may comprise a glass substrate. The coating system comprises a functional layer having reflection properties in the infrared and/or solar radiation range. The functional layer may in particular comprise a metal functional layer, which may for example comprise silver Ag, gold Au, copper Cu, etc., or a combination of said metals or a metal alloy containing one of said metals. Still other non-metal functional materials can be contemplated such as made from appropriate synthetic materials, polymer materials, etc. The coating system may further comprise at least one dielectric layer comprising a dielectric material. The dielectric layer is not in direct contact with the functional layer. The dielectric layer has a geometric thickness of 5 nanometers or more. The dielectric layer comprises titanium oxide TiOₓ and a dopant material. The dopant material comprises at least hafnium Hf. The transparent coated substrate may be provided as a pre-product or product, for example as sheet glass for windows, doors, balustrades, etc., architectural glass, safety glass, glass for automotive appliances such as front shielding, glass with low emissivity ('low-E') properties, solar panels or solar cells such as photovoltaic elements, solar heat elements or solar collector elements, etc. According to various embodiments the transparent substrate may comprise synthetic materials such as plastic glass or synthetic foils, for example foils to be fitted between glass sheets in manufacture of laminated glass.

A coating system may be designated 'temperature resistant', 'thermally resistant' or 'thermally stress resistant' herein when the substrate and the coating system can withstand conditions in a tempering process. One or more tempering processes may be applied, for example, for at least one of the purposes of outgassing and/or passivation of the substrate and/or a layer of the coating system, and for creating balanced internal stresses in a glass substrate for forming a correspondingly pre-stressed glass product.

A tempering process may include heating the coated substrate to a temperature of at least 250°C for a predefined time, heating the coated substrate to a temperature of at least 550°C for a predefined time, and/or heating the coated substrate to a temperature of at least 650°C for a predefined time. The predefined time spans may comprise about one or more hours, and/or may comprise one or more minutes. It may optionally include a further step of rapid cooling after the heating.

A temperature of about 300°C, i.e. a temperature range of about 250°C to about 350°C, is referred to herein as a 'low temperature' and 'low temperature range', respectively, and a corresponding tempering process is referred to as a 'low temperature tempering process'. Similarly, a temperature of about 580°C, i.e. a temperature range of about 530°C to about 630°C, is referred to as an 'intermediate temperature' and 'intermediate temperature range', respectively, and a corresponding tempering process is referred to as an 'intermediate temperature tempering process', while a temperature of about 650°C, i.e. a temperature range of about 600°C to about 700°C, is referred to as a 'high temperature' and a 'high temperature range', respectively, and a corresponding tempering process is referred to as a 'high temperature tempering process'.

The coating system, in particular a titanium oxide layer thereof, is said to withstand a tempering process if any impairment of a desired property of the coating system due to the tempering does not exceed an acceptable limit or threshold. For example, an impairment can be measured to be below an absolute numeric value of a particular property, or a relative impairment can be measured to be below a predefined threshold, wherein the relative impairment may compare a measured property before and after a tempering. Examples of measured properties comprise diffuse reflectivity (haze), refraction index, scattering due to crystallization, luminous transmission, luminous reflection, etc.

The coating system may comprise one or more other layers in addition to the functional layer and the dielectric layer or the TiOₓ layer. According to various embodiments, the TiOₓ layer is not in direct contact with the functional layer because there are one or more other layers arranged between functional layer and dielectric layer.

The functional layer may be arranged intermediate between two oxide and/or metal layers in direct contact with the functional layer, wherein the oxide and/or metal layers are different from the or any dielectric and/or TiOₓ layer. For example, the oxide layer may comprise a seed layer and/or the metal layer may comprise a blocker layer of a pure metal or metal composition or alloy.

The coating system may comprise one or more dielectric and/or TiOₓ layers not in direct contact with the functional layer. For example, a first dielectric TiOₓ layer may be arranged below the functional layer and/or a second dielectric TiOₓ layer may be arranged above the functional layer. In the case more than one dielectric TiOx layers according to the invention are provided in the coating system, the dopant nature and/or quantity may be similar or different for each of these dielectric TiOx layers.

Coating systems may generally comprise one functional layer, or may comprise two or more functional layers, such as, for example, double low-E systems. Multiple functional layers may comprise the same or different functional materials. According to various embodiments, each of the multiple functional layers may be assigned a coating subsystem, which may be similar in configuration to the coating systems with a single functional layer as discussed herein, except, for example, that a coating subsystem may not have a separate protective top coating, and/or a separate sticking layer for sticking onto a lower coating subsystem, but there may be a single top coating and/or a single sticking layer for the entire coating system. However, if a functional layer has assigned one or two dielectric upper and/or lower layers with TiOₓ, such configuration may similarly be repeated for the functional layer of the one or more other coating subsystems. Generally, the configuration of TiOₓ layers as discussed herein may likewise apply to coating systems with a single functional layer as well as multiple functional layers.

As to notation used herein, a functional layer may be provided on one side of a substrate, wherein that side may arbitrarily be referred to as 'upper' side and the functional layer is provided 'above' the substrate. Further in said reference frame, a dielectric layer may be provided between substrate and functional layer and may then said to be 'below' the functional layer, while in case a dielectric layer is provided on a side of the functional layer which is opposite the substrate, the dielectric layer may be said to be 'above' the functional layer.

The dielectric / TiOₓ layer may be provided for one or more purposes, for example to serve as an antireflection coating.

It is known in the art that a TiOₓ layer may comprise a mixture of various oxides of titanium, i.e. the layer may be partially oxidized and may not be deposited in stoichiometric form but in nonstoichiometric form and preferably substoichiometric form of a TiOₓ type, where Ti represents the material titanium and x a number different than the stoichiometry of the titanium oxide TiO₂, i.e. x may differ from 2 and may in particular be less than 2, and may for example represent a stoichiometry between 0.75 times and 0.99 times the normal stoichiometry of the titanium dioxide. Therefore, TiOₓ may for example be present in a layer such that 1.5<=x<=1.98 or 1.5<x<1.7 or even 1.7<x<1.95.

The terms 'dielectric layer' and/or ' TiOₓ layer' may relate to a layer which may comprise titanium oxides as defined herein, but may also comprise other or additional materials, preferably but not exclusively other dielectric materials, for example tin oxides SnOx, zinc oxides ZnO, ZnO:Al, SnZnOx, SiOx, silicon nitrides SiNy, SiOxNy, SiOxNyCz, NbOx, etc.

The coating system may be provided with the dielectric TiOₓ layer prior to any tempering. This is to be understood in contrast to known techniques of providing, for example, a layer of titanium nitride which is intended to be oxidized during a tempering.

The at least one dielectric TiOₓ layer may have a high refractive index of at least 2.0, preferably 2.4, more preferably 2.45, most preferably 2.48, or more prior and/or after any tempering process.

According to various embodiments, the one or more TiOₓ layers may have a thickness larger than a thickness typical for blocker layers, seed layers, top layers, and functional layers, but may have a thickness typical for dielectric layers. The at least one TiOₓ layer may have a geometric thickness of 6 nanometers (nm) or more, preferably 8 nanometers or more, more preferably 10 nanometers or more. Additionally or alternatively, the TiOₓ layer may have a geometric thickness of 100 nanometers or less, preferably 80 nanometers or less, more preferably 50 nanometers or less, most preferably 40 nanometers or less.

According to various embodiments, the functional layer may have a geometric thickness of 6 nanometers or more, preferably 8 nanometers or more, more preferably 10 nanometers or more. Additionally or alternatively, the functional layer may have a geometric thickness of 30 nanometers or less, preferably 20 nanometers or less, more preferably 15 nanometers or less.

According to various embodiments, a blocker layer may be provided which may have a geometric thickness of 0.5 nm or more, preferably 1 nm or more, preferably 2 nm or more. Additionally or alternatively, the blocker layer may have a geometric thickness of 10 nm or less, preferably 5 nanometers or less.

According to various embodiments, a seed layer may be provided below the functional layer which may have a geometric thickness of 1 nanometer or more, preferably 2 nanometers or more. Additionally or alternatively, the seed layer may have a geometric thickness of 20 nanometers or less, preferably 15 nanometers or less, more preferably 10 nanometers or less.

The dielectric TiOₓ layer may comprise a fraction of dopant material in the range of 0.2 at.% - 50 at.%, preferably 0.4 at.% - 30 at.%, more preferably 0.6 at.% - 20 at.%, still more preferably 0.8 at.% - 10 at.%, still more preferably 1 at.% - 4 at.%, most preferably 2 at.% - 3 at.%. As used herein, a value given in units of atomic percent or 'at.%' designates a value of an atomic fraction X / (titanium + X) wherein X may designate any of the dopants discussed herein. As is known, the atomic percent indication may be understood as a percentage fraction of 'number of atoms of the dopant' per 'total number of atoms which may be substituted with the dopant'. In case of oxides, this fraction relates to the metal components only. In the typical range of more than ∼0.5 at.% the dopant concentration can easily be measured by standard techniques, such as x-ray fluorescence spectroscopy for determination of the target composition, or photoelectron emission spectroscopy for the film composition. If the film is part of a multilayer, depth profiling by use of a sputtering gun is naturally applied. The TiOₓ layer may comprise hafnium Hf. According to presently preferred embodiments, a fraction of Hf may amount to 1.5 at.% or more, and/or may amount to 4 at.% or less, preferably 3 at.% or less, more preferably 2 at.% or less.

A coating system comprising one or more Hf-doped dielectric TiOₓ layers may be provided for any kind of tempering process which may include temperatures of at most 300°C, or of at most 600°C, or of at most 700°C.

According to one aspect of the invention, a method of manufacturing a substrate with a coating system as outlined above or elsewhere herein is proposed. The method comprises performing a sputtering process for coating the substrate with at least one of the functional layer and the dielectric layer.

The sputtering process may comprise one or more of the following techniques: DC ("direct current") / AC ("alternating current") sputtering, HF ("high frequency") / RF ("radio frequency") sputtering, reactive sputtering, gas flow sputtering, ion beam sputtering, magnetron sputtering including HiPIMS ("high power impulse magnetron sputtering"), etc.

The sputtering process may be performed at or near a transition point from a metallic state to an oxidic state of a sputtering target.

The substrate may be coated in a plant comprising a sputtering target which provides, for forming the TiOₓ layer on the substrate, a coating material for ejection during a sputtering process and deposition on the substrate. The coating material may comprise titanium. The sputtering target further provides, at least during the sputtering process, a dopant material hafnium in order that the layer of titanium oxide formed on the substrate is doped with the dopant material, for example according to the atomic percentage values outlined above and/or indicated elsewhere herein.

According to various embodiments, the coated substrate may be subjected to a tempering process. The process may comprise heating the coated substrate to a temperature of 250°C, and/or a temperature of 550°C or more, and/or a temperature of 650°C or more.

According to various embodiments, the sputtering process may comprise sputtering the TiOₓ layer to include at least hafnium. According to one aspect, a method of analyzing a substrate with a coating system as described herein may comprise performing a first haze measurement of the coated substrate prior to any tempering process; performing one or more tempering processes; and performing a second haze measurement of the coated substrate after any tempering process. The haze may, e.g., be measured in reflection. Employing one or more of the dopant materials discussed herein for a dielectric TiOₓ layer of the coating system, enables that the haze according to the second measurement in comparison to the haze according to the first measurement is increased by less than a factor of 4, preferably by less than a factor of 3, more preferably by less than a factor of 2.

According to various embodiments, for substrates with a coating system comprising at least one dielectric TiOₓ layer doped as described herein, an impairment of properties due to a tempering process can be minimized in comparison to a similar product however comprising an undoped TiOₓ layer. As a surprising effect, when using one or more of the mentioned dopants, various adverse effects of tempering on a coating system with a TiOₓ layer can be minimized, which is presently assumed to be due to a reduced occurrence of fractures in the coating layer during a tempering process, amongst others.

According to various embodiments, the TiOₓ layer may have an amorphous structure prior to any tempering process. The process of providing a dopant to the layer and/or the presence of the dopant in the layer may act to minimize formation of crystals in the layer which otherwise would form in an undoped layer due to tempering.

For example, crystallization properties of the TiOₓ layer may be affected by the dopant, e.g. the dopant may perturb crystallization, i.e. a formation of crystal structures of the TiOₓ layer during tempering. When compared to the structure of an undoped TiOₓ layer, after tempering an appropriately doped TiOₓ layer may comprise less crystal structures, and/or may comprise structures of only one specific crystal form, such as may comprise either anatase with rutile being suppressed, or rutile with anatase being suppressed, when compared to the undoped layer.

A less prominent crystal phase or only one crystal form instead of two or more forms may lead to a reduction of internal stresses in the TiOₓ layer which may result in a reduced occurrence of fractures in the layer, such that eventually an occurrence of haze in the tempered substrate can be suppressed.

The one or more dielectric layers of a coating system may account for most of the volume of the coating system, as these layers may be considerably thicker than the other layers. Therefore, in case TiOₓ is employed in the dielectric layer or layers, crystallization of the TiOₓ occurring due to tempering may have a particularly adverse effect on the optical properties of the coating system and coated substrate when compared to potential adverse effects in the other, thinner layers. Hence, employing one or more of the dopants proposed herein to prevent or minimize TiOₓ crystallization when employed in a dielectric layer can result in particular prominent improvements. The dopant materials discussed herein may be useful to minimize impairments during specific tempering regimes; for example a dopant material may be particularly suited to minimize adverse tempering effects for a selected one of a low temperature tempering, intermediate temperature tempering, and high temperature tempering, or for two of these three regimes. For example, it may be assumed that a dopant may suppress crystallization only for a specific temperature regime, and/or may suppress the formation of only one or few of the various crystal forms available for TiOₓ; for example, a specific dopant may only prevent or suppress formation of anatase, or of rutile, for a particular temperature regime.

From a manufacturing point of view, a dopant material may be particularly useful if it allows to limit impairments for most if not all desirable tempering regimes. Presently, hafnium is proposed as general dopant in this respect. Employing Hf as a dopant in a dielectric TiOₓ layer may prevent crystallization in a low temperature tempering altogether, and may prevent formation of rutile in intermediate and/or high temperature tempering, and may even prevent formation of anatase in intermediate and/or high temperature tempering when provided with an appropriate dopant concentration. As a result, a coating system comprising a properly Hf-doped TiOₓ layer may flexibly be provided as a pre-product generally suited for a variety of products requiring no tempering and/or different tempering regimes.

The invention allows flexibly providing a transparent substrate equipped with a coating system with an accordingly doped TiOₓ layer, wherein a further manufacturing may or may not include a tempering process, i.e. one and the same coated substrate (as a pre-product) may be provided for a diversity of final products including or not a tempered substrate. Complexity of manufacturing processes and costs thereof can therefore be minimized.

According to various embodiments, TiOₓ layers with proposed dopant materials can be provided based on minor modifications of known manufacturing processes and therefore negligible extra costs. For example, sputtering processes for sputtering the various layers of a coating system with or without additional dopant materials are known as such and can be reconfigured with little effort to provide one or more of the TiOₓ layers with dopant material as discussed herein, for example for providing dielectric layers.

Impairments of, for example, optical properties by tempering may have prevented the use of TiOₓ layers in conventional coating systems. The invention therefore opens new perspectives and a variety of new options for the provision of products based on tempered substrates. For example, favorable optical properties can now be realized at desirable costs.

In the following, the invention will further be described with reference to exemplary embodiments illustrated in the figures, in which:
- Fig. 1A: schematically illustrates an embodiment of a coating system on a substrate in a status of being manufactured in a coating plant;
- Fig. 1B: schematically illustrates a further embodiment of a coating system on a substrate;
- Fig. 2: is a flow diagram illustrating a manufacturing process of the coated substrate of Fig. 1A;
- Fig. 3A: is a graph indicating as an experimental result a crystallization of a titanium oxide layer without any dopant material and without any tempering process;
- Fig. 3B: is a graph illustrating as an experimental result a crystallization of a titanium oxide layer without any dopant material and after a tempering process including a heating to 300°C;
- Fig. 3C: is a graph illustrating as an experimental result a crystallization of a titanium oxide layer without any dopant material and after a tempering process including a heating to 700°C;
- Fig. 4: is a graph illustrating refractive index after tempering vs. oxygen flow in a sputtering configuration for the arrangements of Figs. 3A, 3B, 3C;
- Fig. 5: is a graph illustrating a fraction for various dopants vs. oxygen flow in a sputtering configuration;
- Fig. 6A: is a graph illustrating as an experimental result a crystallization of a titanium oxide layer with hafnium as a dopant material and without any tempering process;
- Fig. 6B: is a graph illustrating as an experimental result a crystallization of a titanium oxide layer with hafnium as a dopant material and after a tempering process including a heating to 300°C;
- Fig. 6C: is a graph illustrating as an experimental result a crystallization structure of a titanium oxide layer with hafnium as a dopant material and after a tempering process including a heating to 700°C;
- Fig. 7: is a graph illustrating refractive index after tempering vs. oxygen flow in a sputtering configuration for the arrangements of Figs. 6A, 6B, 6C;
- Fig. 8A: is a graph illustrating as an experimental result a crystallization of a titanium oxide layer with tantalum as a dopant material and without any tempering (process not according to the invention);
- Fig. 8B: is a graph illustrating as an experimental result a crystallization of a titanium oxide layer with tantalum as a dopant material (not according to the invention) and after a tempering process including a heating to 300°C;
- Fig. 8C: is a graph illustrating as an experimental result a crystallization of a titanium oxide layer with tantalum as a dopant material (not according to the invention) and after a tempering process including a heating to 700°C;
- Fig. 9: is a graph illustrating refractive index after tempering vs. oxygen flow in a sputtering configuration for the arrangements of Figs. 8A, 8B, 8C (not according to the invention);
- Fig. 10A: is a graph illustrating as an experimental result a crystallization of a titanium oxide layer with tungsten as a dopant material (not according to the invention) and without any tempering process;
- Fig. 10B: is a graph illustrating as an experimental result a crystallization of a titanium oxide layer with tungsten as a dopant material (not according to the invention) and after a tempering process including a heating to 300°C;
- Fig. 10C: is a graph illustrating as an experimental result a crystallization of a titanium oxide layer with tungsten as a dopant material (not according to the invention) and after a tempering process including a heating to 700°C;
- Fig. 11: is a graph illustrating a refractive index after tempering vs. oxygen flow in a sputtering configuration for the arrangements of Figs. 10A, 10B, 10C not according to the invention;
- Fig. 12A: is a graph illustrating as an experimental result a crystallization of a titanium oxide layer with zirconium as a dopant material not according to the invention and without any tempering process;
- Fig. 12B: is a graph illustrating as an experimental result a crystallization of a titanium oxide layer with zirconium as a dopant material not according to the invention and after a tempering process including a heating to 300°C;
- Fig. 12C: is a graph illustrating as an experimental result a crystallization of a titanium oxide layer with zirconium as a dopant material not according to the invention and after a tempering process including a heating to 700°C;
- Fig. 13: is a graph illustrating a refractive index after tempering vs. oxygen flow in a sputtering configuration for the arrangements of Figs. 12A, 12B, 12C not according to the invention;
- Fig. 14A: is a graph illustrating as an experimental result a crystallization of a titanium oxide layer with molybdenum as a dopant material not according to the invention and without any tempering process;
- Fig. 14B: is a graph illustrating as an experimental result a crystallization of a titanium oxide layer with molybdenum as a dopant material not according to the invention and after a tempering process including a heating to 300°C;
- Fig. 14C: is a graph illustrating as an experimental result a crystallization of a titanium oxide layer with molybdenum as a dopant material not according to the invention and after a tempering process including a heating to 700°C;
- Fig. 15: is a graph illustrating a refractive index after tempering vs. oxygen flow in a sputtering configuration for the arrangements of Figs. 14A, 14B, 14C not according to the invention;
- Fig. 16A: is a graph illustrating as an experimental result a crystallization of a titanium oxide layer with vanadium as a dopant material not according to the invention and without any tempering process;
- Fig. 16B: is a graph illustrating as an experimental result a crystallization of a titanium oxide layer with vanadium as a dopant material not according to the invention and after a tempering process including a heating to 300°C;
- Fig. 16C: is a graph illustrating as an experimental result a crystallization of a titanium oxide layer with vanadium as a dopant material not according to the invention and after a tempering process including a heating to 700°C;
- Fig. 17: is a graph illustrating a refractive index after tempering vs. oxygen flow in a sputtering configuration for the arrangements of Figs. 16A, 16B, 6C not according to the invention;
- Fig. 18A: is a graph illustrating as an experimental result a crystallization of a titanium oxide layer with chromium as a dopant material not according to the invention and without any tempering process;
- Fig. 18B: is a graph illustrating as an experimental result a crystallization of a titanium oxide layer with chromium as a dopant material not according to the invention and after a tempering process including a heating to 300°C;
- Fig. 18C: is a graph illustrating as an experimental result a crystallization of a titanium oxide layer with chromium as a dopant material not according to the invention and after a tempering process including a heating to 700°C;
- Fig. 19: is a graph illustrating a refractive index after tempering vs. oxygen flow in a sputtering configuration for the arrangements of Figs. 18A, 18B, 18C not according to the invention;
- Fig. 20: illustrates an apparatus for measuring haze of a coated substrate; and
- Fig. 21: is a flow diagram illustrating a measurement process for determining haze due to tempering based on the apparatus of Fig. 20, when the coated substrate comprises a TiOₓ layer a dopant according to the invention.

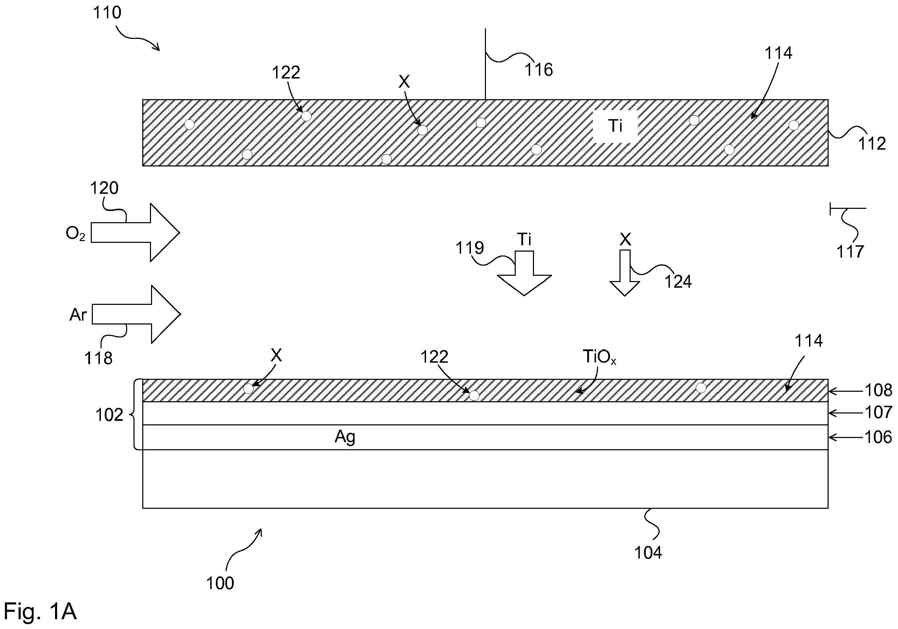

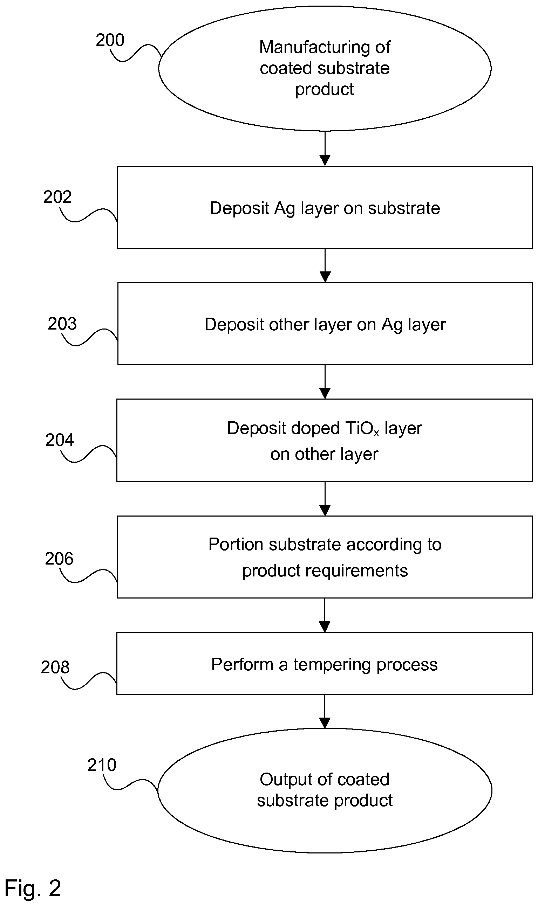

Fig. 1A schematically illustrates a product 100 including a coating system 102 on a substrate 104. The substrate 104 may be assumed a sheet glass and product 100 a safety glass or an architectural glass. The product 100 is illustrated prior to completion, i.e. in an intermediate manufacturing phase. A manufacturing process 200 for manufacturing the product 100 will be described with reference to the flow diagram in Fig. 2.

Generally, the manufacturing process 200 relates to providing the coating system 102 and coating the substrate 104 with the coating system 102, and optionally subjecting the coated substrate / product 100 to a tempering process.

More specifically, substrate 104 may exemplarily comprise glass intended for sheet glass, architectural glass, safety glass, etc., wherein substrate 104 may be intended for undergoing the abovementioned tempering process for reasons of passivation and/or hardening. The coating system 102 is intended to be temperature resistant in order that, when subjected to the tempering process, deterioration of any desired property of the coating system 102 or product 100 is minimized, which may for example concern optical properties such as a transparency, brilliancy, etc. The coating system 102 may for example be intended for the substrate 104 after coating being portioned batch-wise, wherein one batch may be subjected to no tempering, while another batch may be subjected to tempering.

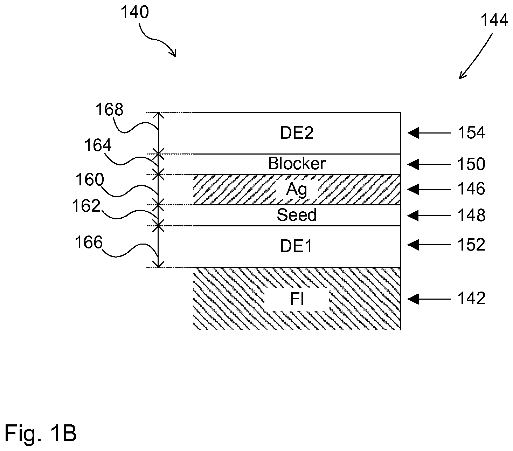

Referring further now to Fig. 2, in a step 202 the substrate 104 may be coated with a functional layer for implementing a desired reflection property. Specifically, a metal functional layer is deposited as layer 106 on the substrate 104, more specifically a silver (Ag) layer 106, i.e. a layer of silver or silver alloy. The step may additionally comprise coating the substrate 104 with one or more other layers prior to coating the silver layer 106, although no such layers are explicitly shown in Fig. 1.

In a step 203, one or more other layers 107 are deposited on the silver layer 106. For example, the other layer or layers 107 may comprise a blocker layer above silver layer 106.

In step 204, further layers are deposited on layer or layers 107; specifically, a dielectric layer 108 comprising a dielectric material is deposited, more specifically a titanium oxide (TiOₓ) layer 108. Fig. 1 illustrates step 204 in more detail. A sputtering configuration 110 comprises a sputtering target 112 comprising a coating material 114. Specifically, the coating material 114 may comprise titanium (Ti). In Fig. 1, portions comprising the coating material 114 of each of the sputtering target 112 and the coating system 102 are depicted with hatching. Fig. 1 illustrates a coating status wherein as a result of a sputtering process performed with the sputtering configuration 110 at least a portion of dielectric layer 108 comprising coated material 114 is already present on substrate 102 and lower layers 106, 107.

In order to perform the sputtering process, the sputtering configuration 110 may for example be embodied as a DC- and/or AC-sputtering. Other sputtering processes based on, e.g., ion beam bombardment can be contemplated by the person of skill. Electrical circuitry 116, 117 may be provided for arranging a DC- and/or AC-voltage between target 112 and substrate 104, wherein it is to be understood that the illustration of electrical circuitry 116, 117 is purely schematic in Fig. 1 and is intended to also cover configurations wherein, for example, neither substrate 104 nor coating system 102 may function as an electrode and therefore one or more separate anodes 117 have to be present as auxiliary structures.

With further regard to sputtering configuration 110, arrow 118 indicates provision of an inert gas such as, in this case, argon (Ar) which provides ions for bombarding target 112. As a result of the bombardment, particles of the coating material 114 are ejected from the target 112. As indicated by arrow 119, ejected titanium particles move towards substrate 104 / layers 106, 107 and are deposited thereupon for forming the coating layer 108.

More specifically, arrow 120 indicates provision of a reactive gas such as, in this case, oxygen (O₂) which may support forming the coating layer 108 of titanium oxide TiOₓ. As is known to the person of skill, a sputtering operation of sputtering the target material 114 / reacted material 119 to the substrate 104/106 may be controlled by controlling the oxygen flow 120. For example, the coating plant providing for the sputtering configuration 110 may provide a process chamber or compartment enabling reactions such as between ejected titanium particles 113 and the reactive gas O₂ 120. Arrow 119 is intended to also indicate that at least some of the reacted TiOₓ particles move towards substrate 104/106 to contribute forming the coating layer 108.

The sputtering configuration may be operated in a transition region wherein the sputtering target is in a metallic state, preferably at an operating point (working point) which is at or near a 'transition point', which may be defined as, when taking the hysteresis effect into account, the point from which absorption-free layers can be deposited, i.e. an absorption of, e.g., visual (solar) or infrared radiation intensity is below a threshold value of, for example, less than 0.05, or 0.03, or 0.01, preferably less than 0.005, or 0.001.

For example, along a return path of the hysteresis, the last oxidic operating point before the metallic regime may be selected as a working point, which would refer to an excess oxygen flux of 0 seem. The values of oxygen flux which are indicated in the following figures 'after a transition point' refer to excess oxygen fluxes in units of sccm (standard cubic centimeters per minute). Generally, as the indicated flux is specific to the sputtering configuration and a metallic target, it is preferable to refer to the total oxygen O₂ flux in the sputtering compartment (or an oxygen partial pressure) at the last oxidic operating point along the hysteresis return path as 100%, and preferred excess oxygen flows are then between 100% and 200% of the flux value (or pressure value), more preferred between 100% and 180%, still more preferred between 100% and 150%.

In the example illustrated in Fig. 1, the sputtering target 112 comprises the coating material 114; as specific examples, the target 112 may essentially be made of titanium, a titanium alloy, but may also comprise titanium oxides, etc. Moreover, the target 112 may be doped, i.e. a dopant X comprising dopant material 122 may be present at or in the target 112 either permanently or be added during the sputtering process. Exemplary portions or areas of the sputtering target 112 and the coating layer 108 comprising the dopant material 122 are depicted with circlets in Fig. 1.

In the configuration of Fig. 1, the dopant material 122 may be mixed with the coating material 114 throughout target 112, wherein 'mixing' may comprise a purely mechanical merging or blending and/or chemical composition comprising coating 114 and dopant 122 material. According to other configurations, additionally or alternatively a dopant material may be provided in a geometrical volume configuration different from that of the target material. For example, the dopant material may be provided as a layer on the sputtering target. Still in other configurations, the dopant material may be mixed with the coating material during deposition from various targets of different composition, by the known method of co-sputtering.

As a result of ion bombardment in the sputter configuration 110 of Fig. 1, in addition to particles of the coating material 114, also particles of the dopant material 122 are ejected from the target 112 during the sputtering process. As indicated by arrow 124, some of the dopant material 122 of dopant X is deposited on top of substrate 104 and lower coating layers 106/107 to form dielectric layer 108 comprising a mixture of TiOₓ and the dopant material X, wherein the dopant material may also be present in the form of one or more oxides.

Step 204 of coating dielectric TiOₓ layer 108 may be followed by coating one or more further layers on top of dielectric layer 108, for example to complete coating system 102. It is noted that a dielectric layer similar to layer 108 located above functional layer 106 may additionally or alternatively also be provided below functional layer 106, which would include performing one or more of the corresponding measures described with reference to step 204 prior to coating the functional layer 106.

In optional step 206, a portioning or cutting of substrate 104 with finalized coating system 102 is performed, wherein, for example, a blanket sheet of coated glass may be portioned into a plurality of glass sheets with dimensions specifically conforming to their intended use in one or more types of end products.

In step 208, the substrate 104 provided with coating system 102 is subjected to a tempering process. Any corresponding heating process may be performed when the product 100 in its pre-product form as illustrated in Fig. 1, optionally after portioning, is still located in the sputtering configuration 110 and/or after transport of the product 100 into a different configuration, e.g. a chamber specifically provided for the tempering and optionally further manufacturing steps.

The tempering process of step 208 may comprise one heating time interval, or several subsequent heating time intervals. According to some embodiments, a tempering process may comprise heating the coated substrate on timescales of order hours to a temperature of about 300°C. According to additional or alternative embodiments, the tempering process may comprise heating the coated substrate on timescales of order minutes to a temperature of about 580°C, and/or heating the coated substrate on timescales of order minutes to a temperature of about 680°C.

In step 210 the manufacturing process 200 terminates. For example, the product 100 may then comprise a batch of sheet glass which has been coated, portioned and wherein each piece of sheet glass is pre-stressed due to tempering.

Fig. 1B illustrates another embodiment of a product 140 comprising a transparent substrate 142 and coating system 144 as may be provided by a system similar to system 100 of Fig. 1 and according to a process similar to that of Fig. 2. The substrate 142 may comprise float glass Fl. The coating system (stack, layer composition) 144 comprises multiple coating layers including a functional layer 146 and various additional supporting layers.

Substrate 142 equipped with coating system 144 may be intended for a low-E product. The functional layer 146 may be intended to implement a desired reflective property and is exemplarily illustrated in Fig. 1B as a silver Ag layer 146. The additional layers may comprise a seed layer 148 for the Ag layer 146; a blocker layer 150 on top of the Ag layer 146; as well as dielectric layers DE1 152 and DE2 154 below and above the metal functional layer 146. Further layers may be provided and/or each of the layers may comprise multiple sub-layers.

According to an exemplary embodiment, the seed layer 148 may comprise zinc oxide ZnO. The blocker 150 may comprise Zn or ZnAl, or oxides or suboxides thereof, sputtered from metallic or ceramic targets. The blocker layer 150 may comprise a metal or metal composition such as Ni, Cr, NiCr, Ti, V, W, Ta, nitrides thereof, oxinitrides, carbides, and mixtures thereof. The dielectric layers 152 and 154 may add desired properties such as antireflective, sticking, and/or protective properties. As but one example, DE1 layer 154 (or a sublayer thereof) may serve as a stick layer to optimize sticking of the coating system 144 on the substrate 142. As another example, DE2 layer 154 (or a sublayer thereof) may serve as a top protective layer for mechanical protection of the coating system 144.

Each of layer DE1 and DE2 may have a substructure comprising several sublayers, or may itself constitute a sublayer of a dielectric layer composition. However, no such details will further be discussed herein purely for reasons of conciseness.

A thickness of the Ag layer 146 may be between about 8 nanometers (nm) and 20 nm. A thickness of the seed layer 148 may be between about 1 nm and 15 nm. A thickness of the blocker layer 150 may be selected between 0.5 nm and 50 nm. A thickness of each of the dielectric layers DE1 152 and/or DE2 154 may be selected between about 10 nm and 50 nm.

The dielectric layers 152 and 154 may comprise TiOₓ and a dopant material X as discussed before. Surprisingly it has been found that an impairment of desired properties of a TiOₓ layer such as one or more of layer 108 of Fig. 1A and layers 152 and 154 of Fig. 1B during a tempering process such as that of step 208 can be minimized when selecting a specific dopant X according to its ability for minimizing any such deterioration. It has been found that such dopant material 122 comprises hafnium wherein this dopant is preferred due to its applicability under a wide range of processing conditions including a variety of tempering processes, robustness against variations in dopant concentration in the dielectric / TiOₓ layer, etc.

However, other dopant materials not according to the invention and for illustrative purpose only may be employed, for example in conjunction with a specific tempering process, with a specific concentration value, etc. Such dopants may include zirconium, molybdenum, chromium and vanadium. Experimental results illustrating the applicability of the various dopant materials are discussed below in more detail.

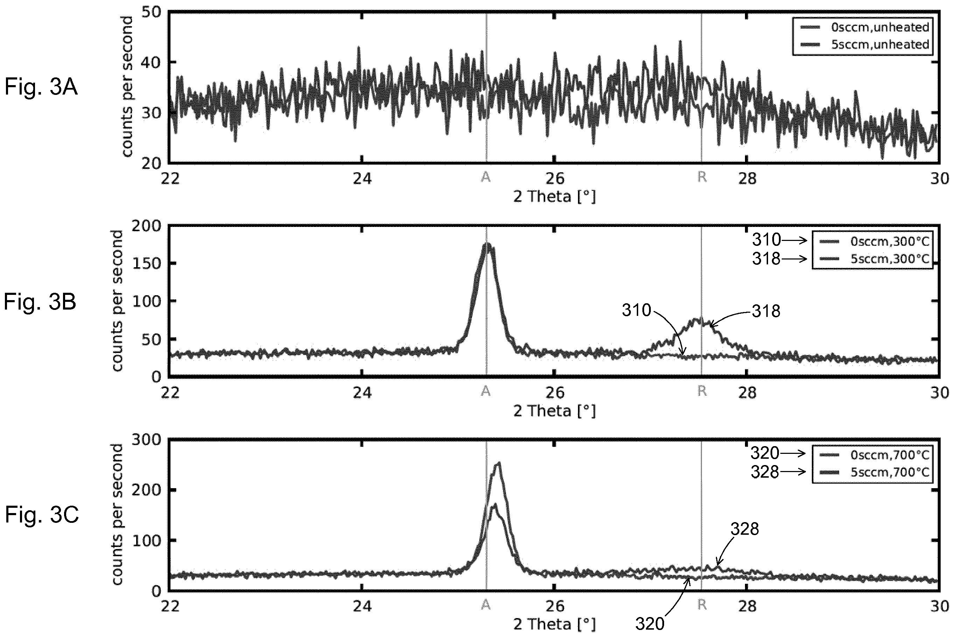

Figs. 3A, 3B and 3C indicate experimental results regarding a crystal structure of a pure titanium oxide (TiOₓ) layer. Specifically, the TiOₓ layer has been sputtered but without any dopant being present in the sputtering configuration. The figures show graphs of 'counts per second' vs. scattering angle, wherein the count rate may have been determined by, e.g., X-ray diffraction scans. The scattering angle is arbitrarily indicated as "2 Theta" in units of degrees (°). Preferred scattering angles for the crystal structures anatase (A) and rutile (R) are indicated by vertical lines.

Fig. 3A indicates a crystallization of a sputtered undoped titanium oxide layer prior to any tempering, i.e. without any heating. Specifically, according to Fig. 3A the sputtered, dopant-free and unheated titanium oxide layer has an entirely amorphous structure. In particular, there is no preference for a crystal structure such as anatase or rutile.

Fig. 3B indicates a crystallization of an undoped titanium oxide layer after a tempering process including a heating to 300°C. In contrast to the amorphous layer structure prior to tempering as shown in Fig. 3A, presence of pronounced crystalline structures are indicated by the peaks of the two graphs given in Fig. 3B.

Specifically, two different oxygen flows 310, 318 are shown, which can be understood as implementations of the oxygen flow 120 of Fig. 1. The oxygen flows 310, 318 are arbitrarily indicated for a particular experimental configuration in units of sccm (standard cubic centimeters per minute); more precisely, an excess oxygen flow after a transition point is indicated, wherein the transition point may be selected as the last oxidic operating point before the metallic regime along a return path of a hysterese behaviour for a sputtering configuration, as discussed above. Therefore, even if oxygen flow 310 is indicated with "0 seem", flow 310 in fact includes a finite amount of an oxygen flow, i.e. is different from a vanishing oxygen flow. For a specific sputtering configuration, an oxygen flow at the transition point may, for example, amount to 5 seem. It is to be mentioned that all numbers given, here e.g. "5 sccm oxygen flow", are to be taken as example only, showing the situation on a small test coater with target diameters of e.g. 80mm. Situation and values of oxygen flow above a transition point may change for other coaters with other geometrical situation, especially for industrial glass coater with cathode length above 2.5m or even above 3.3m.

As shown in Fig. 3B, due to the heating, crystal structures have been formed in the TiOₓ layer for both the excess oxygen flows 310, 318 of 0 sccm and 5 seem, respectively. Independent of excess oxygen flow, pronounced anatase structures are present. Further, for an (excess) oxygen flow of 5 seem, additional rutile structures formed in the TiOₓ layer.

It is assumed that the general formation of crystalline structures during a tempering process such as that illustrated in Fig. 3B can lead to stresses in the TiOₓ layer which may then further result in crack formation and corresponding deterioration of optical properties. In case two different crystalline structures with different unit cell sizes are present, such as anatase and rutile, it can be assumed that crack formation and corresponding impairment is even further stimulated.

Fig. 3C indicates a crystallization of an undoped TiOₓ layer after a tempering process including a heating to 700°C. Experimental results are presented for two different excess oxygen flows 320, 328 of 0 sccm and 5 seem, respectively. Due to the tempering, again the titanium oxide layer has changed its structure as compared to Fig. 3A. In particular, pronounced anatase structures are present. For an oxygen flow 320 of 0 seem, the anatase structures are more prominent as for an oxygen flow 328 of 5 seem. On the other hand, for the higher oxygen flow 328, measurable additional rutile structures formed in the layer.

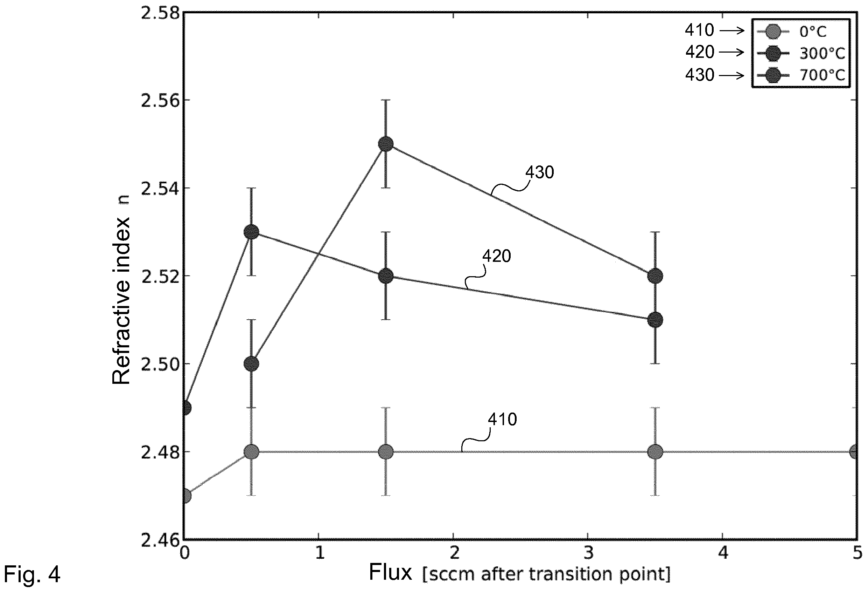

Fig. 4 indicates various graphs of refractive index n of the titanium oxide layers of Figs. 3A, 3B and 3C vs. oxygen flow during sputtering of the titanium oxide layers. Generally, the presence or absence of specific crystal structures can result in a change of refractive index compared to, e.g., an amorphous structure. For example, it is known that anatase and rutile structures, respectively, can lead to different refractive indices.

Specifically, graph 410 indicates refractive indices n for the undoped titanium oxide layer without any heating for various oxygen flows, as depicted in Fig. 3A. Graph 420 indicates refractive indices n for an undoped titanium oxide layer with a heating to 300°C for various oxygen flows, as depicted in Fig. 3B. Graph 430 indicates refractive indices n for an undoped titanium oxide layer with a heating to 700°C for various oxygen flows, as depicted in Fig. 3C.

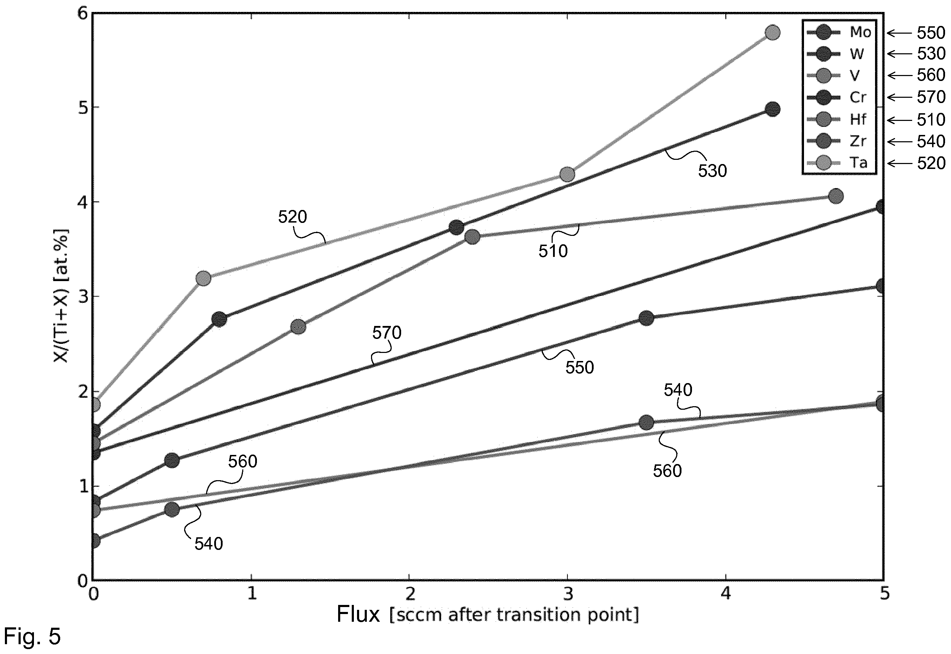

As illustrated in Fig. 4, there is a tendency that a refractive index of a TiOₓ layer increases due to tempering. It is assumed that the formation of crystal structures including anatase and/or rutile contributes significantly to the change in index. For general applicability of a TiOₓ layer, a refractive index would be preferable, which is independent of any tempering, indifferent as to whether or not a tempering process is applied to the TiOₓ layer, and which kind of tempering process is applied. A constant refractive index would enable common manufacturing processes for pre-products regardless of whether or not some or all of the products are subjected to tempering after coating. Fig. 5 illustrates fraction vs. oxygen flow for various dopants for a specific sputtering configuration. The dopants may represent specific implementations of the dopant 'X' in Fig. 1A. Specifically, fractions X / (Ti + X) in atomic percent (at.%) have been measured for various dopants X in a sputtering configuration for sputtering a correspondingly doped TiOₓ coating layer for use as, e.g., a dieletric layer in a coating system. The dopants comprise hafnium (510) according to the invention and tantalum (520), tungsten (530), zirconium (540), molybdenum (550), vanadium (560), and chromium (570) not according to the invention. As generally illustrated in Fig. 5, different dopant fractions in the TiOₓ layer can be achieved by different oxygen flows in the sputtering configuration. Of course, additional or alternative parameters may be used to control a desired dopant concentration in the TiOₓ layer. Regarding variations in excess oxygen flow, for various appliances there may be a preference for excess flows near to the transition point, i.e. near to a flux of 0 sccm as indicated in Fig. 5. For example, minimizing an oxygen flux during sputtering may minimize adverse effects on the TiOₓ layer such as unwanted contaminations thereof. However, for other appliances, minimizing the oxygen flow may be less important and higher excess oxygen fluxes might be of interest, for example in order to achieve a specific dopant concentration, if desirable.

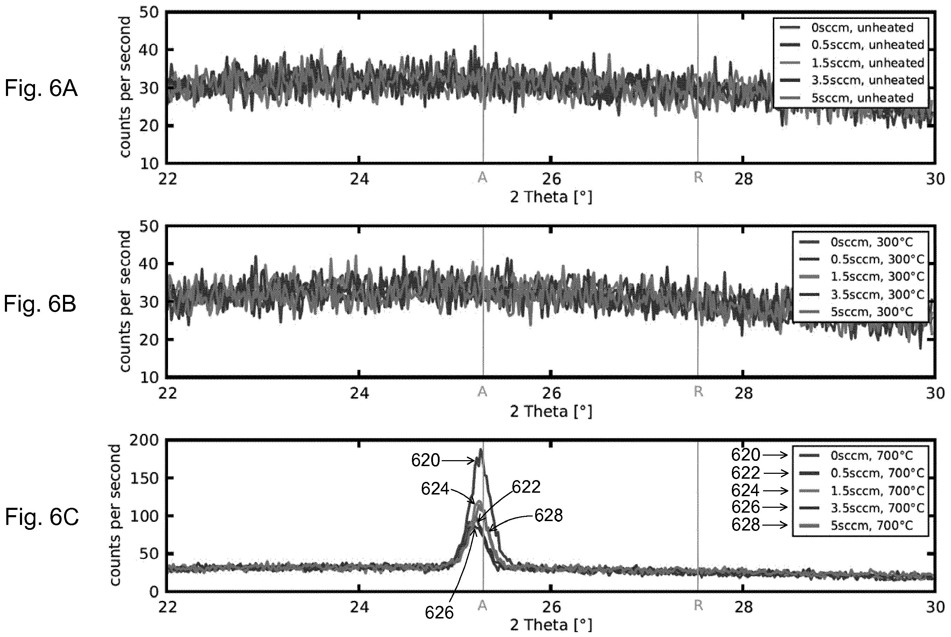

Figs. 6A, 6B and 6C indicate experimental results regarding a crystallization of a TiOₓ layer with hafnium Hf as a dopant material. The presentation in these and the subsequent corresponding figures is similar to what has been discussed for Figs. 3A - 3C, except as stated otherwise.

Fig. 6A indicates a crystallization of a titanium oxide layer with hafnium prior to any tempering, i.e. without any heating, for different oxygen flows. According to Fig. 6A, the titanium oxide layer with dopant and without heating has an amorphous structure without any preference for a crystalline structure such as anatase or rutile.

Fig. 6B indicates a crystallization of a titanium oxide layer with hafnium after a tempering process including a heating to 300°C. The crystallization is indicated for various excess oxygen flows between 0 sccm and 5 seem. Although being heated, the doped titanium oxide layer remains amorphous. No measurable crystalline structures are present, neither anatase nor rutile, which is to be seen in contrast to the undoped TiOₓ layer of Fig. 3B showing the presence of pronounced crystal structures after tempering.

Fig. 6C indicates a crystallization of a titanium oxide layer doped with hafnium after a tempering process including a heating to 700°C. The crystallization is indicated for oxygen flows of 0 sccm (620), 0.5 sccm (622), 1.5 sccm (624), 3.5 sccm (626), and 5 sccm (628) after the transition point.

Generally, due to tempering, the titanium oxide layer has changed its crystallization as compared to Fig. 6A and in particular anatase structures are present in the tempered layer. However, the presence of rutile structures can be prevented even for high excess oxygen flows. This is in contrast to the undoped titanium oxide layer of Fig. 3C, which would require high oxygen flows (328) to minimize occurrence of anatase crystals, however at the expense of formation of rutile structures.

Further it is noted from a comparison of the peak count rates of Figs. 6C and 3C that doping with hafnium enables minimizing a presence of anatase in the titanium oxide layer already for moderate oxygen flows which are considerably lower than that required for an undoped layer. Transforming the configuration specific oxygen flows into dopant concentrations based on Fig. 5, it is concluded that a fraction of hafnium may be selected as low as about 1.5 at.% or may be selected in a range of about 1.5 at.% to 2.5 at.%.

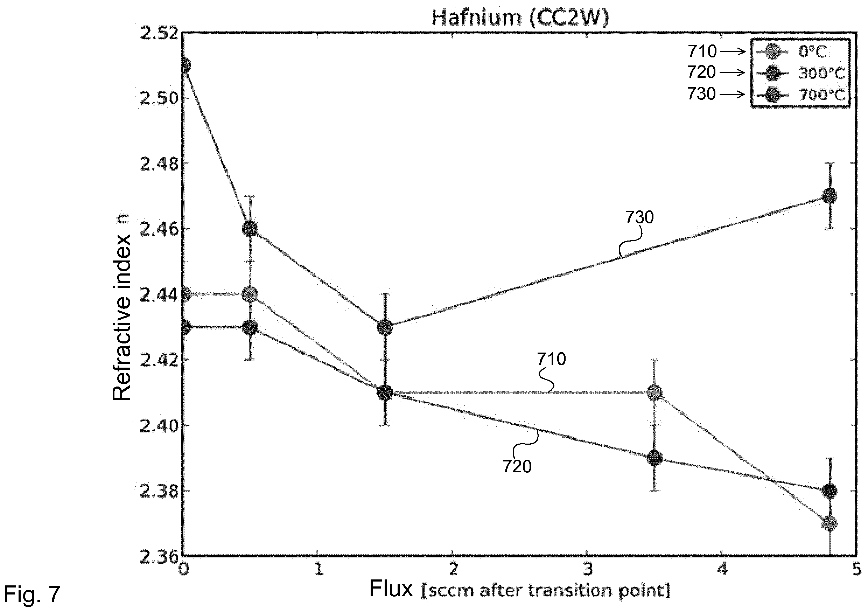

Fig. 7 indicates refractive indices of the titanium oxide layers of Figs. 6A, 6B and 6C vs. oxygen flow (resulting, e.g., in different dopant concentrations and thus crystallization degrees) during sputtering of the TiOₓ layers. Specifically, graph 710 indicates refractive indices for a titanium oxide layer doped with hafnium without any heating for various oxygen flows, as depicted in Fig. 6A. Graph 720 indicates refractive indices n for a titanium oxide layer doped with hafnium and tempered with a heating to 300°C for various oxygen flows, as depicted in Fig. 6B. Graph 730 indicates refractive indices n for a titanium oxide layer with hafnium as a dopant after being tempered with a heating to 700°C for various oxygen flows, as depicted in Fig. 7C.

The tempering to 300°C (720) does essentially not change the refractive index of the doped titanium oxide coating layer, which conforms to the absence of any crystalline structure in Fig. 6B and which may or may not be understood from the dopant hafnium in a concentration as indicated above preventing the formation of crystal structures such as anatase and rutile altogether during the tempering.

For a tempering to 700°C, the dopant hafnium can prevent the formation of rutile, but cannot entirely prevent the formation of anatase, at least for some values of oxygen flow. Therefore the refractive index 730 is increased over that of the unheated titanium oxide layer 710. However, for an oxygen flow in the range of about 0.5 sccm to 1.5 seem, corresponding to about 2 at.% - 3 at.% according to Fig. 5, the increase of refractive index apparently can be minimized.

As a result, by providing hafnium as a dopant in a TiOₓ layer, e.g. for use as a dielectric layer which generally has a larger thickness than other layers including, e.g., blocker layers or seed layers, a deterioration of the TiOₓ layer due to tempering can be minimized and therefore the TiOₓ layer is suitable for any coating system regardless of whether the coating system is intended for no tempering or low temperature, intermediate or high temperature tempering. Formation of rutile structures can be prevented altogether. Anatase structures may be present after high temperature tempering, however, can be limited to a considerably lower level as compared to an undoped TiOₓ layer. A change of refractive index can be minimized, if not suppressed entirely.

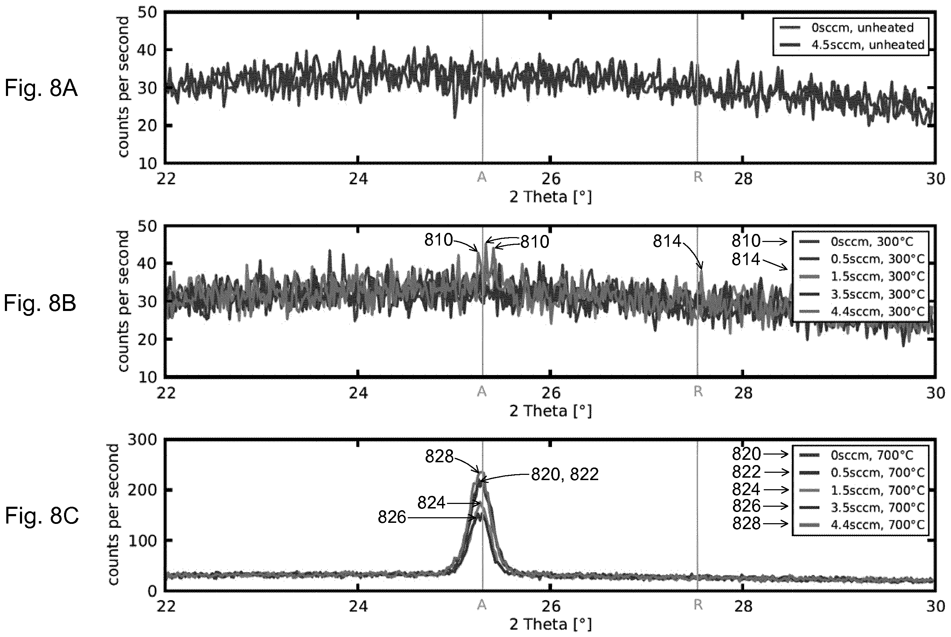

Figs. 8A, 8B and 8C indicate experimental results regarding a crystal structure of a TiOₓ layer with tantalum Ta as a dopant material not according to the invention. Fig. 8A indicates a crystallization of a titanium oxide layer with tantalum prior to any tempering, i.e. without any heating, for different oxygen flows. According to Fig. 8A, the titanium oxide layer with dopant and without heating has an amorphous structure without preference for any crystalline structure.

Fig. 8B indicates a crystallization of a titanium oxide layer with tantalum after a tempering process including a heating to 300°C. From the various graphs representing different oxygen flows, the oxygen flows of 0 sccm and 4.4 sccm are referenced by numerals 810 and 814, respectively. From graph 810, there might be slight evidence for a presence of anatase structures. From graph 814, there might be slight evidence for a presence of some rutile structures instead of anatase structures at higher excess oxygen levels. However, as can be clearly inferred from a comparison of count rates in Figs. 8B and 3B, the doped titanium oxide layer is still essentially amorphous. Fig. 8C indicates a crystallization of a titanium oxide layer doped with tantalum after a tempering process including a heating to 700°C. The crystallization is indicated for excess oxygen flows of 0 sccm (820), 0.5 sccm (822), 1.5 sccm (824), 3.5 sccm (826), and 4.4 sccm (828).

Generally, due to the tempering the titanium oxide layer has changed its crystallization as compared to the layer of Fig. 8A, i.e. anatase structures are present in the tempered layer. However, the presence of any rutile structure can be prevented even for high excess oxygen flows. This is an advantage over the undoped titanium oxide layer of Fig. 3C, which would require high oxygen flows (328) to minimize occurrence of anatase crystals.

Further, an oxygen flow between about 1.5 sccm (824) and about 3.5 sccm (826) results in minimizing the presence of anatase structures. The flows may be somewhat lower than would be applied (328) in the case of the undoped layer in Fig. 3C.

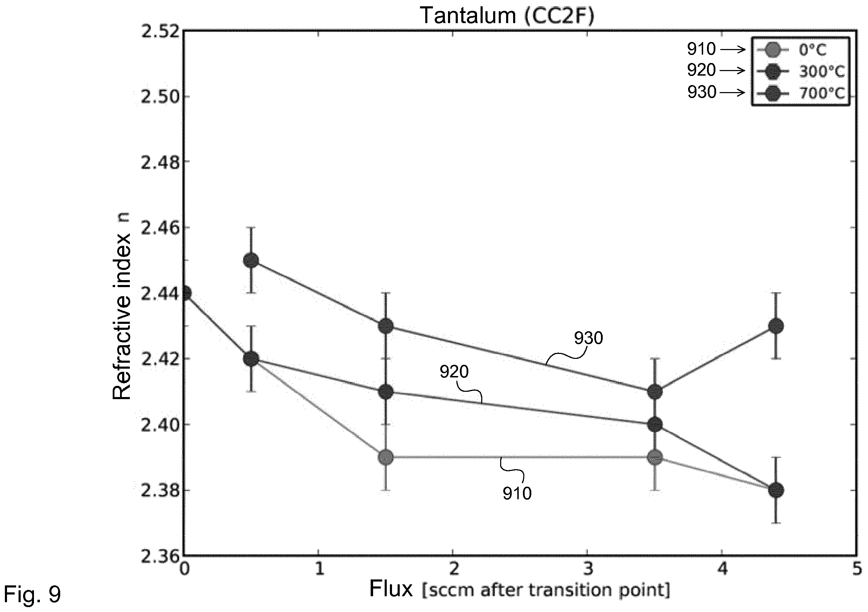

Fig. 9 illustrates refractive indices of the titanium oxide layers of Figs. 8A, 8B and 8C vs. oxygen flow during sputtering of the titanium oxide layers. Specifically, graph 910 indicates refractive indices for a titanium oxide layer doped with tantalum without any heating for various oxygen flows, as depicted in Fig. 8A. Graph 720 indicates refractive indices n for a titanium oxide layer doped with tantalum and tempered with a heating to 300°C for various oxygen flows, as depicted in Fig. 8B. Graph 930 indicates refractive indices for a titanium oxide layer with tantalum as a dopant after being tempered with a heating to 700°C for various oxygen flows, as depicted in Fig. 9C.

The tempering to 300°C (920) tends to slightly increase the refractive index n of the doped titanium oxide coating layer, which conforms to the tendency of few crystalline structures being present according to Fig. 8B and which may be understood from the dopant tantalum in the concentration as related to the applied oxygen flow during sputtering as discussed above minimizing the formation of anatase or rutile structures but not preventing the formation thereof altogether.

During a tempering to 700°C (930), the dopant tantalum can prevent the formation of rutile, but cannot entirely prevent the formation of anatase. Therefore the refractive index 930 increases over that of the unheated titanium oxide layer.

As a result, by providing Ta as a dopant in a TiOₓ layer, e.g. a dielectric layer, an impairment of the TiOₓ layer due to tempering can be minimized. A TiOₓ coating layer doped with Ta can generally be employed and is particularly suitable for no tempering or a low temperature tempering. For intermediate or high temperature tempering, a dopant concentration may for example be selected between about or around 4 at.% (see Fig. 5) for minimizing any impairment of optical properties of the coating and product which may occur due to the tempering.

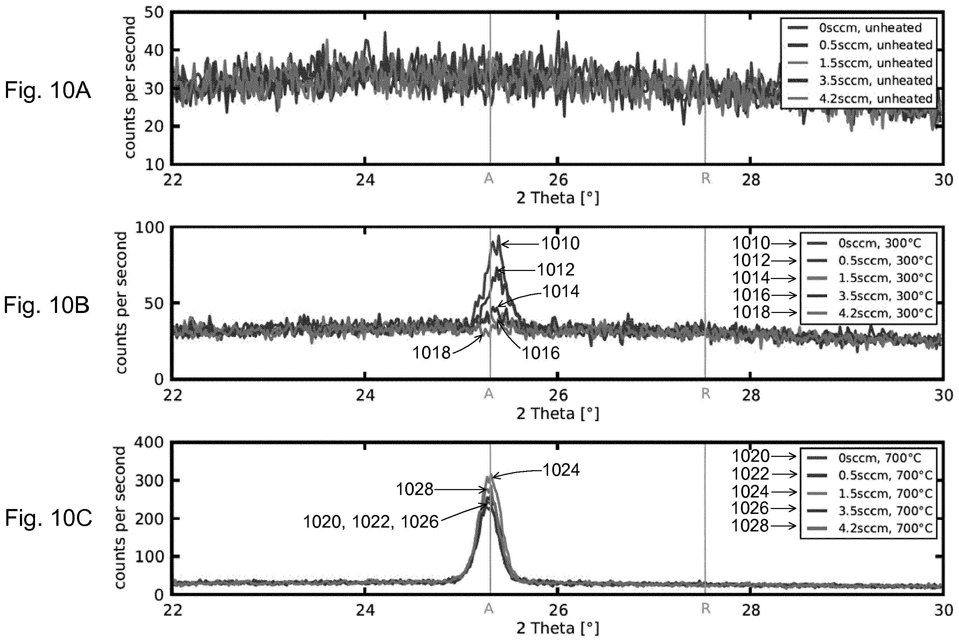

Figs. 10A, 10B and 10C indicate experimental results regarding a crystal structure of a TiOₓ layer with tungsten W as a dopant material not according to the invention. Fig. 10A indicates a crystallization of a titanium oxide layer with tungsten prior to any tempering, i.e. without any heating for different oxygen flows. According to Fig. 10A, the titanium oxide layer with dopant and without heating has an amorphous structure without preference for any crystalline structure.

Fig. 10B indicates crystallization of a titanium oxide layer with tungsten after a tempering process including a heating to 300°C. The structures are indicated for oxygen flows of 0 sccm (1010), 0.5 sccm (1012), 1.5 sccm (1014), 3.5 sccm (1016), and 4.2 sccm (1018). Employing tungsten as a dopant may generally prevent formation of rutile during the tempering. Further, an increasing oxygen flow, which might correspond to an increasing concentration of tungsten in the titanium dioxide layer, results in a reduction in the formation of anatase structures in the layer during tempering. Specifically, moderate oxygen flows in the range of about 0 sccm (1020) to 0.5 sccm (1012) lead to a reduction of the presence of anatase structures compared to the corresponding undoped titanium oxide layer of Fig. 3B (compare the count rates). For oxygen flows above about 1.0 seem, the formation of anatase structures can essentially be prevented.

Fig. 10C indicates a crystallization of a titanium oxide layer doped with tungsten after a tempering process including a heating to 700°C. The crystallization is indicated for oxygen flows of 0 sccm (1020), 0.5 sccm (1022), 1.5 sccm (1024), 3.5 sccm (1026), and 4.2 sccm (1028).

Generally, due to tempering the titanium oxide layer has changed its crystallization as compared to Fig. 10A, i.e. anatase structures are present in the tempered layer. However, the presence of any rutile structure can be prevented even for low excess oxygen flows, which is an advantage over an undoped titanium oxide layer requiring higher oxygen flows which may be applied to minimize anatase and which is not able to suppress parallel presence of anatase and rutile structures, see Fig. 3C.

However, there is no clear evidence that any specific value of oxygen flow in the tested range particularly minimizes the presence of anatase in the tempered titanium oxide layer.

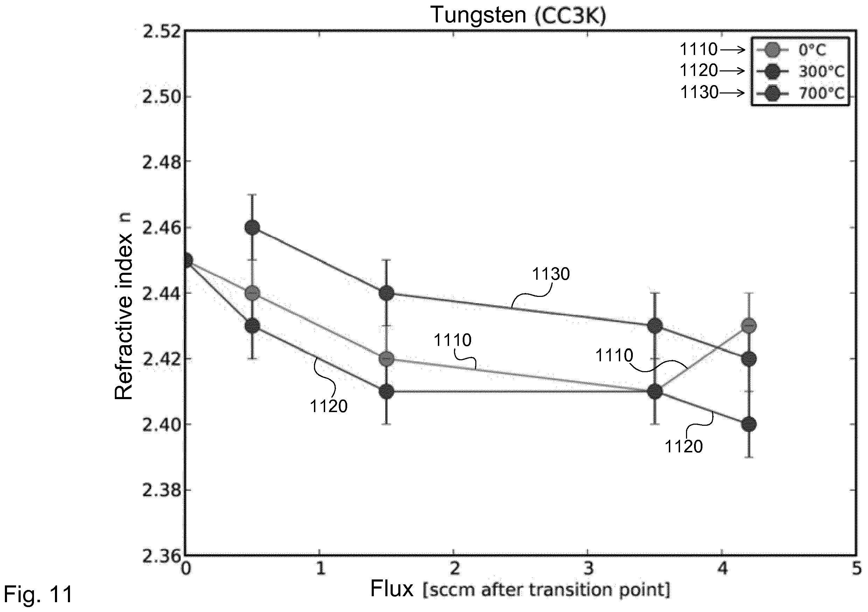

Fig. 11 indicates refractive indices of the titanium oxide layers of Figs. 10A, 10B, and 10C vs. oxygen flow during sputtering of the titanium oxide layers. Specifically, graph 1110 indicates refractive indices for a titanium oxide layer doped with tungsten without any heating for various oxygen flows, as depicted in Fig. 10A. Graph 1120 indicates refractive indices for a titanium oxide layer doped with tungsten and tempered with a heating to 300°C for various oxygen flows, as depicted in Fig. 10B. Graph 1130 indicates refractive indices for a titanium oxide layer with tungsten as a dopant after being tempered with a heating to 700°C for various oxygen flows, as depicted in Fig. 10C.

The tempering to 300°C (1120) does not markedly affect the refractive index n of the doped titanium oxide coating layer, which conforms to the tendency of few anatase crystalline structures being present according to Fig. 10B, and wherein no crystal structures appear to be present for oxygen flows above about 1.5 seem. Apparently the presence of tungsten in the concentrations corresponding to said oxygen flow during sputtering minimizes the formation of anatase structures and therefore minimizes a corresponding deterioration of optical properties.

During a tempering to 700°C (1130), the dopant tungsten can prevent the formation of rutile, but cannot prevent the formation of anatase, see Fig. 11C. Therefore the refractive index 1130 appears to increase over that of the titanium oxide layer before heating. However, the increase appears to be of the order of 1.6 % for a flux between 0 sccm to 3 seem, which may be tolerable for various appliances.

As a result, by providing tungsten as a dopant in a TiOₓ layer, an impairment of the TiOₓ layer due to tempering can be minimized. A TiOₓ layer with a dopant concentration in the range of about 1.5 at.%. or more, preferably 2.5 at.% or more, more preferably 3 at.% or more (see Fig. 5) can generally be employed either for no tempering or for a low temperature tempering, as with said concentration a deterioration of optical properties of the coating and the product due to the tempering is minimized by preventing formation of rutile and minimizing a formation of anatase.

A TiOₓ layer with tungsten as a dopant may also be employed for an intermediate or high temperature tempering. A formation of rutile may be prevented in this regime. However, existing experimental data indicate that formation of anatase cannot significantly be reduced as compared to an undoped TiOₓ layer, and therefore (and/or for another reason) there is a tendency for a slight increase in refractive index. However, tungsten may be considered as a dopant for TiOₓ layers when accounting for further properties, for example because tungsten may be less costly than other potential dopants.

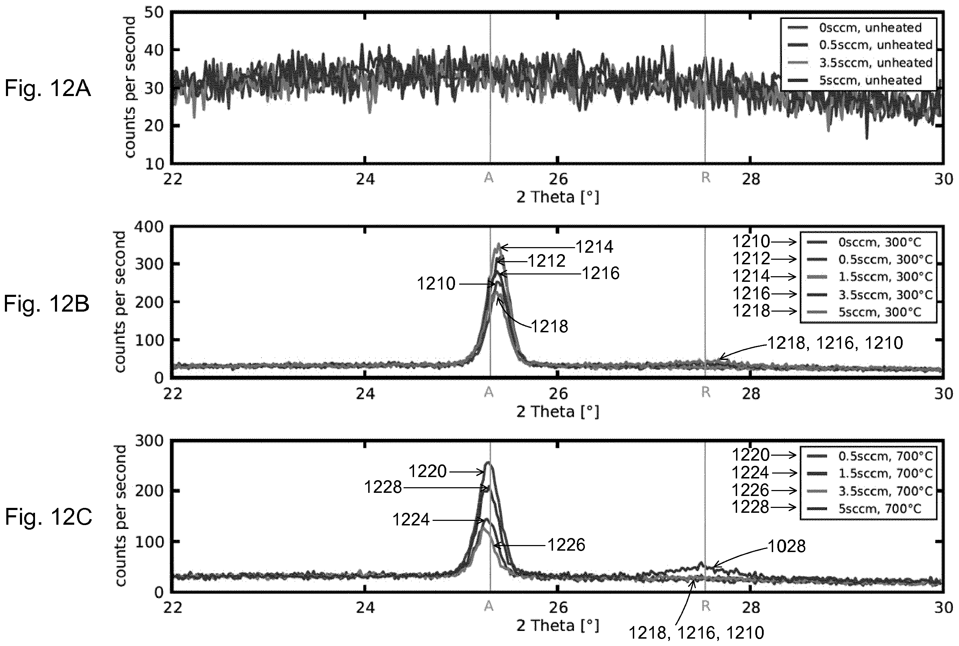

Figs. 12A, 12B and 12C indicate experimental results regarding a crystal structure of a TiOₓ layer with zirconium Zr as a dopant material not according to the invention. Fig. 12A indicates a crystallization of a titanium oxide layer with zirconium prior to any tempering, i.e. without any heating, for different oxygen flows. According to Fig. 12A, the titanium oxide layer with dopant and without heating has an amorphous structure without preference for any crystalline structure.

Fig. 12B indicates a crystallization of a titanium oxide layer with zirconium after a tempering process including a heating to 300°C. The crystallization is indicated for excess oxygen flows of 0 sccm (1210), 0.5 sccm (1212), 1.5 sccm (1214), 3.5 sccm (1216), and 5 sccm (1218). Employing zirconium as a dopant might tend to slightly reduce a formation of rutile during low temperature tempering. However, there is a tendency for rutile formation for low oxygen flow (1210) as well as oxygen flows above about 3.5 sccm (1218, 1216).

At least in the tested range of oxygen flows (dopant concentrations), there is no clear tendency as to an influence of the dopant on the formation of anatase. Generally, it appears that anatase formation is not suppressed as compared to tempering an undoped TiOₓ layer, see Fig. 3B.

Fig. 12C indicates crystallization of a titanium oxide layer doped with zirconium after a tempering process including a heating to 700°C. The crystallization is indicated for oxygen flows of 0.5 sccm (1222), 1.5 sccm (1224), 3.5 sccm (1226), and 5.0 sccm (1228). Generally, anatase and rutile structures are present. The presence of rutile cannot entirely be suppressed for high oxygen flows. There is also no clear tendency of whether or not formation of anatase would be suppressed due to the presence of the dopant in the TiOₓ layer.

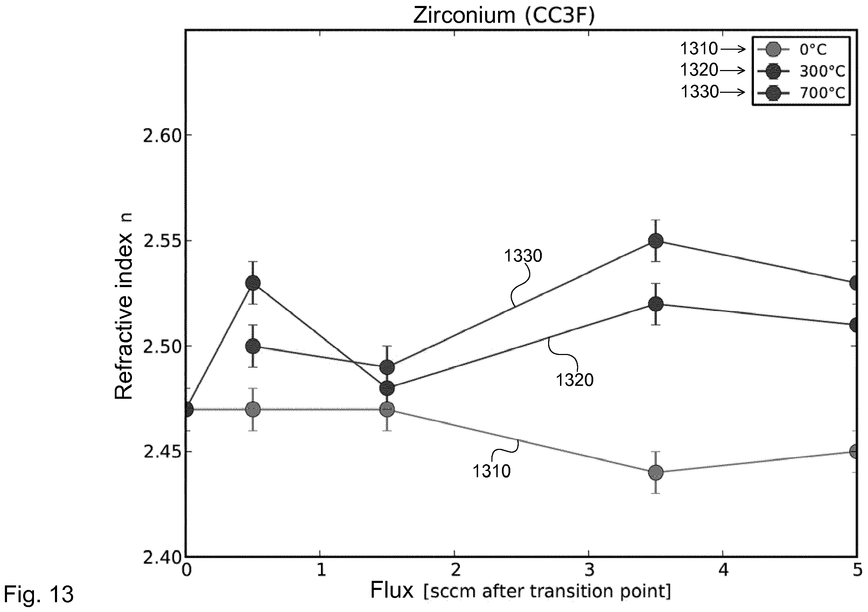

Fig. 13 indicates refractive indices of the doped TiOₓ layers of Figs. 12A, 12B and 12C vs. oxygen flow during sputtering for the titanium oxide layers. Specifically, graph 1310 indicates refractive indices for a titanium oxide layer doped with zirconium without any heating for various oxygen flows, as depicted in Fig. 12A. Graph 1320 indicates refractive indices for a titanium oxide layer doped with zirconium and tempered with a heating to 300°C for various oxygen flows, as depicted in Fig. 12B. Graph 1330 indicates refractive indices for a titanium oxide layer with zirconium as a dopant after being tempered with a heating to 700°C for various oxygen flows, as depicted in Fig. 12C.

There is a tendency that tempering increases the refractive index over that of the unheated doped titanium oxide layer. This conforms to Figs. 12B and 12C indicating that Zr as a dopant is not generally suited to avoid crystallization in a TiOₓ layer during tempering, except possibly for specific dopant concentrations and/or tempering regimes.

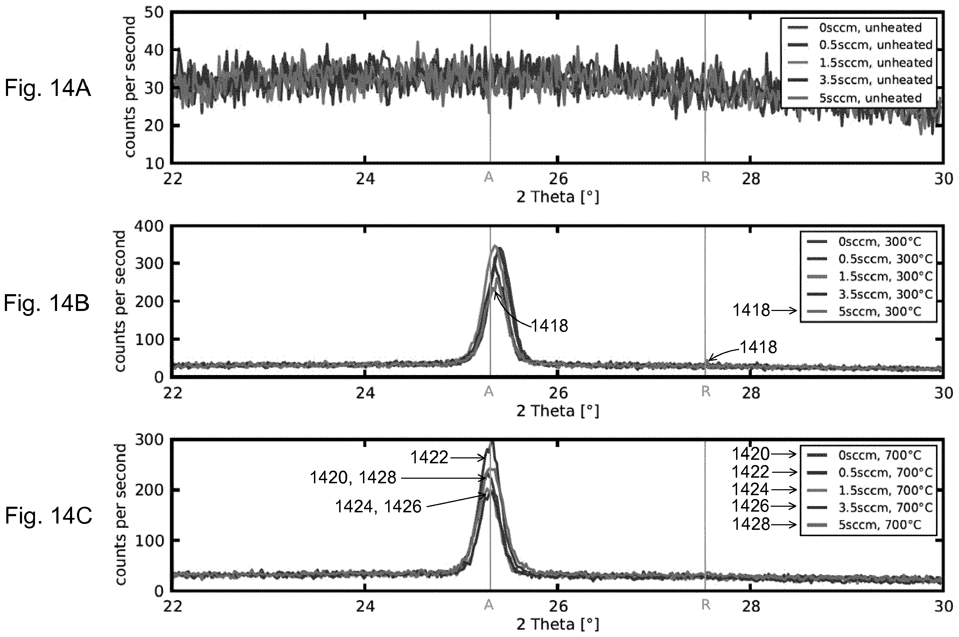

Figs. 14A, 14B and 14C indicate experimental results regarding a crystallization of a TiOₓ layer with molybdenum Mo as a dopant material not according to the invention. Fig. 14A indicates a crystallization of a titanium oxide layer with molybdenum prior to any tempering, i.e. without any heating, for different oxygen flows. According to Fig. 14A, the titanium oxide layer with dopant and without heating has an amorphous structure without preference for any crystalline structure.

Fig. 14B indicates a crystallization of a titanium oxide layer with molybdenum after a tempering process including a heating to 300°C. Generally, due to the tempering the titanium oxide layer has changed its structure as compared to Fig. 14A, i.e. pronounced anatase structures are present in the tempered layer. Employing molybdenum as a dopant of either concentration appears to prevent formation of rutile during the tempering. The presently available experimental results provide however no clear tendency for specific oxygen flows (dopant concentrations) particularly suitable for minimizing a formation of anatase.

Fig. 14C indicates crystallization of a titanium oxide layer doped with molybdenum after a tempering process including a heating to 700°C. Generally, due to the heating the titanium oxide layer has changed its structure as compared to Fig. 14A, i.e. anatase structures are present in the tempered layer. Anatase formation seems not to be suppressed by the presence of molybdenum. However, the presence of rutile can apparently be suppressed.

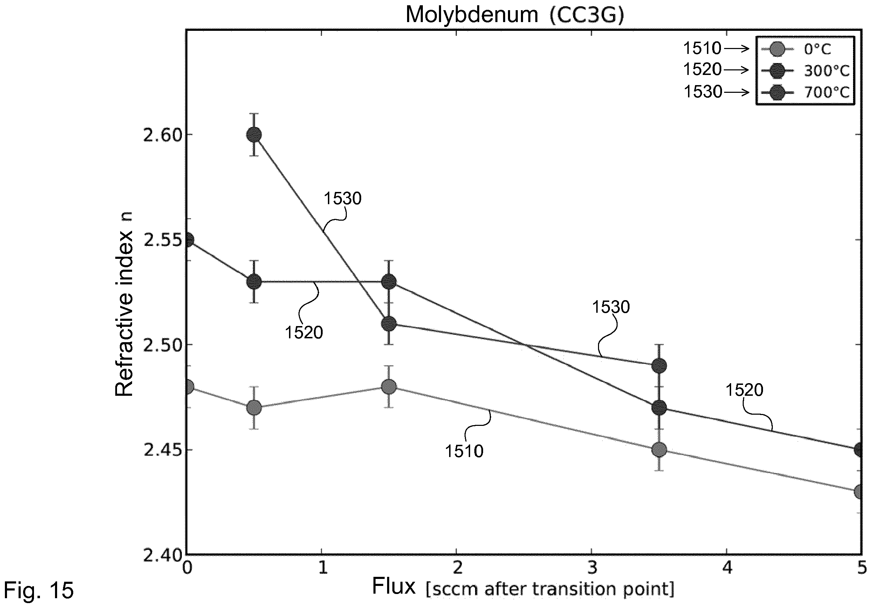

Fig. 15 illustrates refractive indices of the titanium oxide layers of Figs. 14A, 14B and 14C vs. oxygen flow for during sputtering of the titanium oxide layers. Specifically, graph 1510 indicates refractive indices for a titanium oxide layer doped with molybdenum without any heating for various oxygen flows, as depicted in Fig. 14A. Graph 1520 indicates refractive indices for a titanium oxide layer doped with molybdenum and tempered with a heating to 300°C for various oxygen flows, as depicted in Fig. 14B. Graph 1530 indicates refractive indices n for a titanium oxide layer with molybdenum as a dopant after being tempered with a heating to 700°C for various oxygen flows, as depicted in Fig. 14C.

Any tempering, regardless of whether only to 300°C (1520), or to 700°C (1530), appears to increase the refractive index over that of the unheated doped titanium oxide layer (1510). This conforms to Figs. 14B and 14C indicating the pronounced formation of anatase. Therefore, while it appears that with Mo as a dopant the parallel presence of different crystal forms such as anatase and rutile can be prevented, crystallization as such cannot be prevented. Mo as a dopant may therefore be preferred as a dopant for TiOₓ layers for more specific applications.

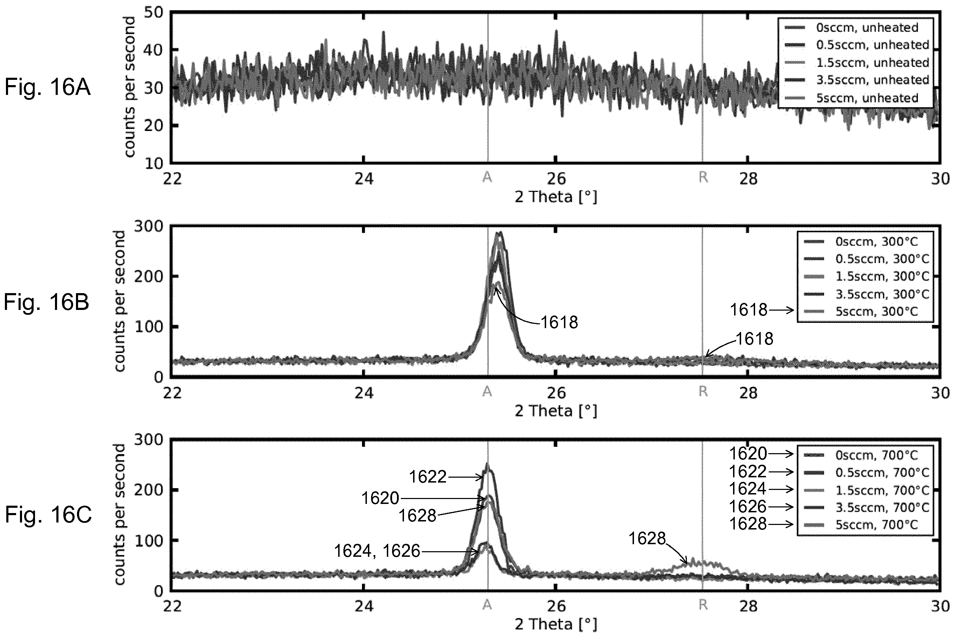

Figs. 16A, 16B and 16C indicate experimental results regarding a crystal structure of a TiOₓ layer with vanadium as a dopant material not according to the invention. Fig. 16A indicates a crystallization of a titanium oxide layer with vanadium prior to any tempering, i.e. without any heating, for different oxygen flows. According to Fig. 16A, the titanium oxide layer with dopant and without heating has an amorphous structure without preference for any specific crystalline structure.

Fig. 16B indicates a crystallization of a titanium oxide layer with vanadium after a tempering process including a heating to 300°C. Generally, due to the heating the titanium oxide layer has changed its crystallization as compared to the layer of Fig. 16A, i.e. anatase structures are present in the tempered layer. The presently available experimental results provide no clear tendency for specific oxygen flows or dopant concentrations particularly suitable for minimizing a formation of anatase, except that for large excess oxygen flows of order 5 sccm (1618) the anatase formation appears to be suppressed. However, there is a parallel tendency for rutile formation for said high excess oxygen flows.

Fig. 16C indicates crystallization of a titanium oxide layer doped with vanadium after a tempering process including a heating to 700°C. The crystallization is indicated for oxygen flows of 0.0 sccm (1620), 0.5 sccm (1622), 1.5 sccm (1624), 3.5 sccm (1426), and 5.0 sccm (1628). Generally, due to the tempering the titanium oxide layer has changed its structure as compared to the layer of Fig. 16A, i.e. anatase structures are present in the tempered layer. There is no clear tendency of whether or not specific dopant concentrations might suppress a formation of anatase. The presence of rutile cannot be prevented for high excess oxygen flows (1628).

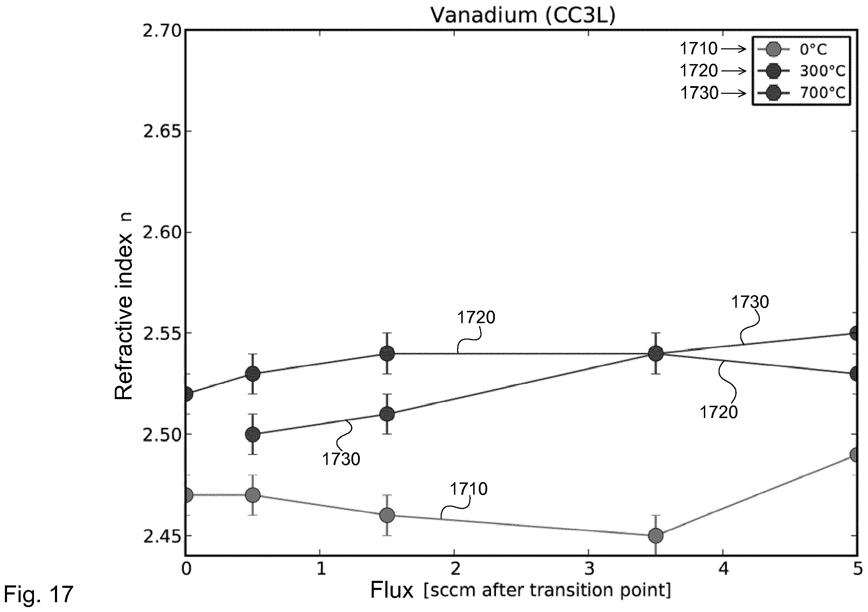

Fig. 17 illustrates refractive indices of the titanium oxide layers of Figs. 16A, 16B and 16C vs. oxygen flow during sputtering of the titanium oxide layers. Specifically, graph 1710 indicates refractive indices for a titanium oxide layer doped with vanadium without any heating for various oxygen flows, as depicted in Fig. 16A. Graph 1720 indicates refractive indices for a titanium oxide layer doped with vanadium and tempered with a heating to 300°C for various oxygen flows, as depicted in Fig. 16B. Graph 1730 indicates refractive indices n for a titanium oxide layer with vanadium as a dopant after being tempered with a heating to 700°C for various oxygen flows, as depicted in Fig. 16C.

There is a tendency of any tempering to increase the refractive index over that of the doped titanium oxide layer without tempering, which conforms to the general tendency of Figs. 16B and 16C of pronounced formation of at least anatase. As a result, while a doping with vanadium may prevent the parallel presence of the different crystalline structures anatase and rutile in a tempered TiOₓ layer, crystal formation cannot be prevented altogether. Therefore using vanadium as a dopant in a TiOₓ layer, e.g. a dielectric layer, might be considered suitable preferably for more specific applications.

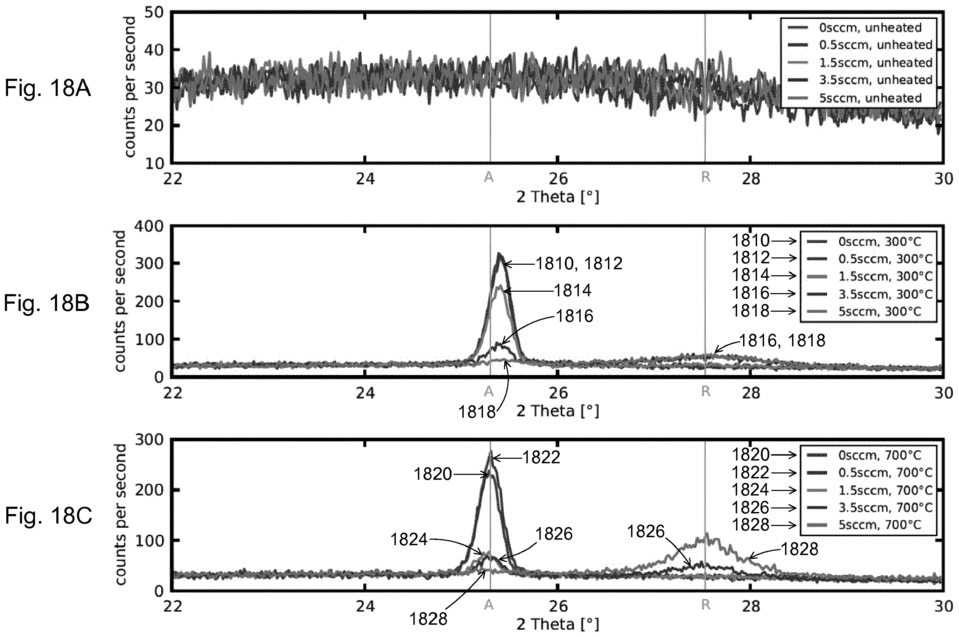

Figs. 18A, 18B and 18C indicate experimental results regarding a crystal structure of a TiOₓ layer with chromium Cr as a dopant material not according to the invention. Fig. 18A indicates a crystallization of a titanium oxide layer with chromium prior to any tempering, i.e. without any heating, for different oxygen flows. According to Fig. 18A, the titanium oxide layer with dopant and without heating has an amorphous structure without preference for any specific crystalline structure.

Fig. 18B indicates a crystallization of a titanium oxide layer with chromium after a tempering process including a heating to 300°C. The crystal structures are indicated for oxygen flows of 0.0 sccm (1810), 0.5 sccm (1812), 1.5 sccm (1814), 3.5 sccm (1816), and 5.0 sccm (1818) after the transition point. Generally, due to the heating the titanium oxide layer has changed its structure as compared to the layer of Fig. 18A, i.e. anatase structures are present in the tempered layer except for high excess oxygen flows, when however rutile is present.

More specifically, for oxygen flows above about 1.5 sccm (1814), there is a tendency for anatase formation being increasingly suppressed. For an oxygen flow at about 3.5 sccm (1816), anatase formation is suppressed also in comparison to a tempered undoped titanium oxide layer, see Fig. 3B. However, for oxygen flows of 3.5 sccm or more (1816, 1818), measurable rutile formation occurs. In other words, for oxygen flows of more than 3.5 sccm and corresponding dopant concentrations, the titanium oxide layer can be controlled to comprise essentially only rutile as a crystal structure.

Fig. 18C indicates a crystallization of a titanium oxide layer doped with chromium after a tempering process including a heating to 700°C. The crystallization is indicated for excess oxygen flows of 0.0 sccm (1820), 0.5 sccm (1822), 1.5 sccm (1824), 3.5 sccm (1826), and 5.0 sccm (1828). Generally, due to the heating the titanium oxide layer has changed its structure as compared to the layer of Fig. 18A, i.e. anatase and/or rutile structures are present in the tempered layer. Specifically, an oxygen flow of about 1 sccm or more, preferably about 1.5 sccm (1824) or more, minimizes the presence of anatase in the tempered titanium oxide layer also in comparison to a tempered undoped titanium oxide layer, see Fig. 3C. The indicated oxygen amounts may be lower than required for an undoped titanium oxide layer to minimize anatase formation. An onset of rutile formation is detected for about 3.5 sccm or more (1826, 1828) in the experimental configuration.

Therefore, two different regimes can be envisaged: At moderate flow rates in the range of about 1 sccm to 2 sccm or 3 sccm of oxygen flux in the specific experimental configuration, anatase formation can be minimized also in comparison to a tempered undoped titanium oxide layer, see Fig. 3C. For amounts of 3.5 sccm or more, the formation of anatase can be minimized or prevented altogether, however, rutile forms during the tempering.

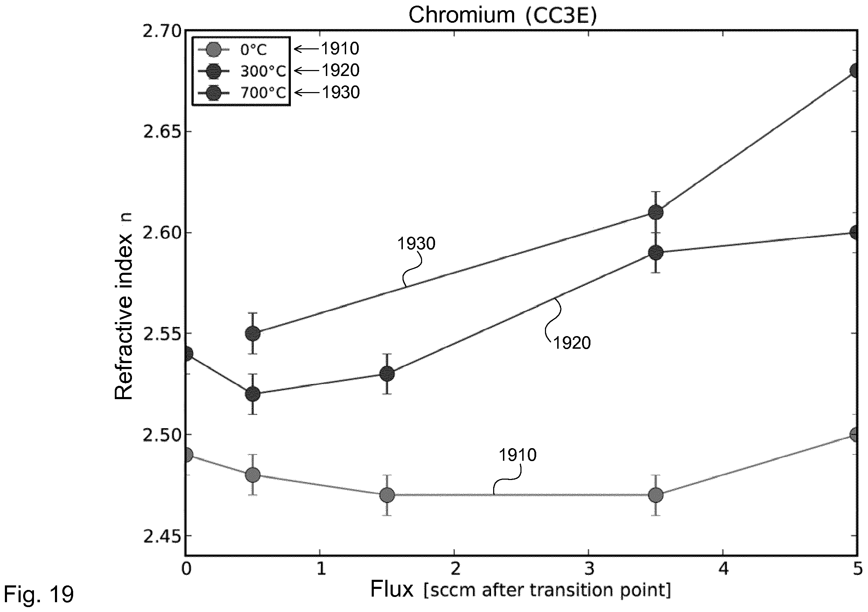

Fig. 19 illustrates refractive indices of the titanium oxide layers of Figs. 18A, 18B and 18C vs. oxygen flow during sputtering of the titanium oxide layers. Specifically, graph 1910 indicates refractive indices for a titanium oxide layer doped with chromium without any heating for various oxygen flows, as depicted in Fig. 18A. Graph 1920 indicates refractive indices for a titanium oxide layer doped with chromium and tempered with a heating to 300°C for various oxygen flows, as depicted in Fig. 18B. Graph 1930 indicates refractive indices for a titanium oxide layer with chromium as a dopant after being tempered with a heating to 700°C for various oxygen flows, as depicted in Fig. 18C.

Any tempering increases the refractive index over that of the unheated doped titanium oxide layer. Specifically, the index increases for a tempering at 300°C with increasing oxygen flow, which conforms to Fig. 18B showing decreasing formation of anatase, but increasing formation of rutile. A tempering at 700°C shows a similar behaviour, however more pronounced, which conforms to Fig. 18C showing the pronounced appearance of rutile at higher excess oxygen flows.

As a result, chromium seem not to be suited as a dopant which can generally suppress an impairment of optical properties of a TiOₓ layer during tempering. However, there appears to be a specific range of dopant concentration which suppresses an anatase formation prior to the onset of massive rutile formation and therefore minimizes crystallization. From the experimental data, it appears such range is about 2 at.% to about 3 at.% (Fig. 5).

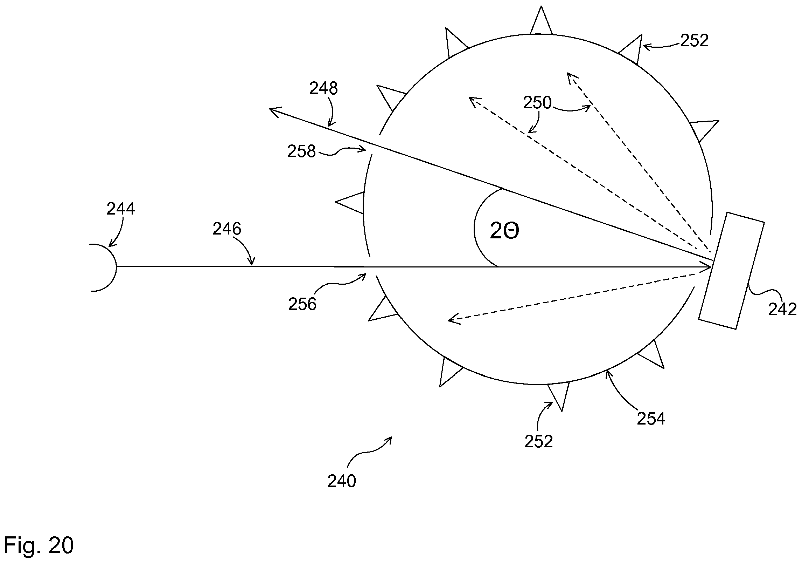

Fig. 20 schematically illustrates an apparatus 240 for measuring haze (haziness, scattered light) of a coated substrate 242. The degree of haziness in either transmission or reflection, as known to the person of skill, is another quantifiable measure of a coated transparent substrate. For most applications / products, a low degree of diffuse reflection is preferable. The coated substrate may be an embodiment of (pre-)product 100 of Fig. 1A or product 140 of Fig. 1B. Apparatus 240 may be arranged separately or in association with a manufacturing system, e.g. the system 100 of Fig. 1A, for example for product quality inspection and testing.

The apparatus 240 comprises a visual or infrared light source 244 for directing an incident light beam 246 onto substrate 242 with an incidence angle Θ. The incident light may comprise specular reflection mostly due to the reflective properties of the functional layer. The corresponding reflected light beam 248 forms an angle 2Θ with the incident light beam 246. A typical value for said angle may be 2Θ = 8°.

Apparatus 240 provides for a measurement of diffuse reflection, schematically illustrated with various beams (dashed arrows) 250, by means of a manifold of detectors 252 arranged in form of a sphere 254. The sphere 254 may be populated densely or sparsely with detectors 252, wherein in the latter case areas of the sphere 254 devoid of detectors should absorb reflected light. In any case, the sphere 254 may have an opening (solid angle) 256 for the incident light beam 246, and another opening 258 for the specular reflection beam 248.

A degree of diffuse reflection or haze of the coated substrate may result, amongst other disturbances, from cracks and other scattering sources within the one or more TiOₓ layers of the coating system, which scattering may come about from subjecting the coated substrate 242 a tempering process. Proper measurement schemes can be employed to prove the usefulness of the various dopants proposed herein.

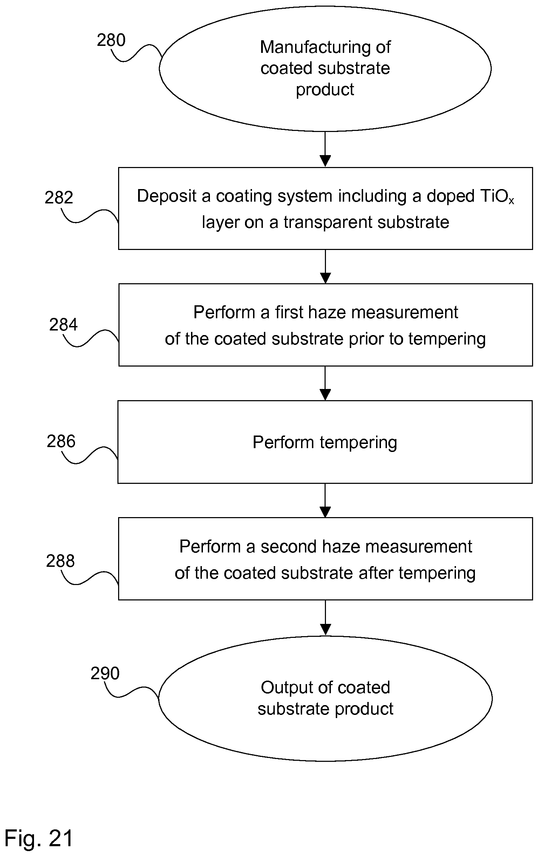

Accordingly, an exemplary operation 280 of apparatus 240 will further be described with reference to the flow diagram of Fig. 21. The operation 280 may be integrated into a process of manufacturing a coated substrate, examples of which are discussed herein. Nevertheless, for sake of illustration, step 282 refers to depositing a coating system such as system 100 of Fig. 1A or system 140 of Fig. 1B on a transparent substrate. Step 282 may comprise, for example, steps 202 and 204 of Fig. 2. Step 282 may result in provision of the coated substrate 242 depicted in Fig. 20 however prior to any tempering.

In step 284, a first haze measurement of the coated substrate is performed. It is the intention of this step to measure the coated substrate prior to any tempering which may be considered adding to haziness. In case several tempering processes are performed, wherein only one specific tempering may contribute significantly to haze (e.g., the highest temperature tempering), step 284 can be performed after a tempering process deemed uncritical, but prior to the critical tempering.

For the first measurement, light source 246 of apparatus 240 irradiates a light beam 246 with intensity I via opening 256 in sphere 254 onto the coated substrate 242. Specular reflection of beam 246 results in beam 248 leaving sphere 254 via opening 258. Intensity of beam 248 may or may not be measured. Diffuse reflection R (arrows 250) is measured by the plurality of detectors 252. As a result, a dimensionless haze value H1 may be represented as H1 = R / I.

In step 286, the coated substrate 242 is subjected to one or more tempering processes, which may comprise any one or more of the low temperature, intermediate or high temperature tempering processes discussed herein, and may in particular comprise a critical tempering as discussed above. The or any tempering process may act upon the one or more dielectric TiOₓ layers of the coating system. Tempering might result in a particular degree of crystallization depending on the particular tempering process. One or more of the dopants discussed herein would suppress crystal formation during tempering, as discussed in detail above.

In step 288, a second haze measurement of the coated and tempered substrate 242 is performed, wherein the second haze measurement resulting in a value H2 may be performed in exactly the same way as the first measurement in step 284 in order to be able to compare the first H1 and second H2 haze measurements and to thereby detect a degree of haziness caused by the tempering process.

In step 290, a result of the process 280 may be output. For example, an increase in haziness due to tempering may be measured and output as Δ = R2 / R1. Assuming that any added haziness is due to tempering-induced changes in the one or more TiOₓ layers of the coating system, the role of the dopants proposed herein for the TiOₓ layers can be examined and quantified. For any of the dopants, such as for example Hf, Ta, and/or W, it is noted that a result Δ can be achieved, wherein Δ ≤ 4, preferably Δ ≤ 3, more preferably Δ ≤ 2, i.e. the haziness is increased by a factor of two or less when employing at least one of the proposed dopants in the TiOₓ layer or layers of a coating system, in particular in one or more dielectric layers of the coating system.

It is noted that haziness, and an increase in haziness, may not only be measured in reflection as exemplarily illustrated in Fig. 20, but may also be measured in transmission, with similar results.

Various embodiments of the invention propose hafnium as dopant for a titanium oxide layer, such as a dielectric layer, of a coating system for supporting a functional layer on a substrate. According to various embodiments, the hafnium dopant can generally be employed to avoid impairment of properties of the TiOₓ layer during a tempering. The resulting coating system can generally be employed regardless whether or not a tempering of a product is intended, which increases a manufacturing flexibility.

Examples of Low-E coating systems wherein one or more dielectric layer(s) comprising doped titanium oxide TiOₓ according to the invention may be included are:
- Glass / doped TiOx / ZnO / Ag / ZnO:Al / (optionally: doped TiOx) / SnZnOx / SiNy
- Single Low E: Glass / optional barrier layer / DE1 / Seed layer 1 / Ag1 / Blocker1 / DE2 / optional protective top layer
- Double Low E: Glass / optional barrier layer / DE1 / Seed layer 1 / Ag1 / Blocker1 / DE2 / Seed layer 2 / Ag 2/ Blocker 2 / DE3 / optional protective top layer
- Triple Low E: Glass / optional barrier layer / DE1 / Seed layer 1 / Ag1 / Blocker1 / DE2 / Seed layer 2 / Ag 2/ Blocker 2 / DE3 / Seed layer 3 / Ag 3 / Blocker 3 / DE4 /optional protective top layer

## Claims

1. A coated transparent substrate (104, 142), such as a glass substrate, coated with a temperature resistant coating system (102, 144),
wherein the coating system (102, 144) comprises a functional layer (106, 146) having reflection properties in the infrared and/or solar radiation range, in particular a metal functional layer comprising silver or a metal alloy containing silver, and at least one dielectric layer (108, 152, 154) comprising a dielectric material,
wherein the at least one dielectric layer (108, 152, 154) is not in direct contact with the functional layer (106, 146),
wherein the at least one dielectric layer (108, 152, 154) has a geometric thickness of 5 nanometers or more,
and wherein the at least one dielectric layer (108, 152, 154) comprises titanium oxide TiOₓ (114, 119) and a dopant material (122, 124) comprising hafnium Hf.

2. The coated substrate according to claim 1,
wherein the dielectric layer (108, 152, 154) has a geometric thickness of 8 nanometers or more, preferably 10 nanometers or more.

3. The coated substrate according to claim 1 or 2,
wherein the dielectric layer (108, 152, 154) has a geometric thickness of 100 nanometers or less, preferably 80 nanometers or less, more preferably 50 nanometers or less, most preferably 40 nanometers or less.

4. The coated substrate according to any of the preceding claims,
wherein the dielectric layer (108, 152, 154) comprises a fraction of dopant material in the range of 0.2 at.% - 50 at.%, preferably 0.4 at.% - 30 at.%, more preferably 0.6 at.% - 20 at.%, still more preferably 0.8 at.% - 10 at.%, still more preferably 1 at.% - 4 at.%, most preferably 2 at.% - 3 at.%.

5. The coated substrate according to any of the preceding claims,
wherein the at least one dielectric layer is part of a first dielectric layer (152) below the functional layer (146) and/or of a second dielectric layer (154) above the functional layer (146).

6. The coated substrate according to any of the preceding claims,
wherein the functional layer (146) is intermediate between two oxide (148) and/or metal (150) layers in direct contact with the functional layer (146).

7. The coated substrate according to any of the preceding claims,
wherein the substrate withstands heat treatment.

8. The coated substrate according to any of the preceding claims,
wherein the substrate comprises at least one of sheet glass, architectural glass, safety glass, antireflective glass, glass for solar panels, glass for automotive applications.

9. A method of manufacturing a coated transparent substrate (104, 142), such as a glass substrate, coated with a temperature resistant coating system (102, 144),
wherein the coating system (102, 144) comprises a functional layer (106, 146) having reflection properties in the infrared and/or solar radiation range, in particular a metal functional layer comprising silver or a metal alloy containing silver, and at least one dielectric layer (108, 152, 154) comprising a dielectric material,
wherein the at least one dielectric layer (108, 152, 154) is not in direct contact with the functional layer (106, 146),
wherein the at least one dielectric layer (108, 152, 154) has a geometric thickness of 5 nanometers or more, wherein the at least one dielectric layer (108, 152, 154) comprises titanium oxide TiOₓ (114, 119) and a dopant material (122, 124) comprising hafnium Hf, and
wherein the method comprises performing a sputtering process (202, 204) for coating the substrate (104) with at least one of the functional layer and the dielectric layer.

10. The method according to claim 9, comprising performing the sputtering process at or near a transition point from a metallic state to an oxidic state of a sputtering target.

11. The method according to claim 9 or 10, comprising tempering the substrate coated with the coating system at a temperature of 250°C or more, and/or a temperature of 500°C or more, and/or a temperature of 650°C or more.

12. A method of analyzing the substrate according to any one of claims 1 to 8, comprising
performing (284) a first haze measurement of the coated substrate prior to any tempering process;
performing (286) one or more tempering processes; and
performing (288) a second haze measurement of the coated substrate after any tempering process, wherein the haze according to the second measurement in comparison to the haze according to the first measurement is increased by less than a factor of 4, preferably less than a factor of 3, more preferably less than a factor of 2.

13. The method according to claim 12,
wherein the haze is measured in reflection.

## Patentansprüche

1. Beschichtetes transparentes Substrat (104, 142), wie zum Beispiel ein Glassubstrat, das mit einem temperaturbeständigen Beschichtungssystem (102, 144) beschichtet ist,
wobei das Beschichtungssystem (102, 144) eine Funktionsschicht (106, 146) mit Reflexionseigenschaften im Infrarot- und/oder Solarstrahlungsbereich, insbesondere eine Metallfunktionsschicht, die Silber oder eine silberhaltige Metalllegierung enthält, und mindestens eine, einen dielektrischen Stoff enthaltende, dielektrische Schicht (108, 152, 154) umfasst,
wobei sich die mindestens eine dielektrische Schicht (108, 152, 154) nicht in unmittelbarem Kontakt mit der Funktionsschicht (106, 146) befindet,
wobei die mindestens eine dielektrische Schicht (108, 152, 154) eine geometrische Dicke von 5 Nanometer oder mehr aufweist,
und wobei die mindestens eine dielektrische Schicht (108, 152, 154) Titanoxid TiOₓ (114, 119) sowie einen Hafnium Hf enthaltenden Dotierstoff (122, 124) umfasst.

2. Beschichtetes Substrat nach Anspruch 1,
wobei die dielektrische Schicht (108, 152, 154) eine geometrische Dicke von 8 Nanometer oder mehr, vorzugsweise von 10 Nanometer oder mehr aufweist.

3. Beschichtetes Substrat nach Anspruch 1 oder 2,
wobei die dielektrische Schicht (108, 152, 154) eine geometrische Dicke von 100 Nanometer oder weniger, vorzugsweise von 80 Nanometer oder weniger, weiter bevorzugt von 50 Nanometer oder weniger, höchst bevorzugt von 40 Nanometer oder weniger aufweist.

4. Beschichtetes Substrat nach einem der vorhergehenden Ansprüche,
wobei die dielektrische Schicht (108, 152, 154) einen Anteil an Dotierstoff im Bereich von 0,2 at% bis 50 at%, vorzugsweise 0,4 at% bis 30 at%, weiter bevorzugt 0,6 at% bis 20 at%, noch weiter bevorzugt 0,8 at% bis 10 at%, noch weiter bevorzugt 1 at% bis 4 at%, höchst bevorzugt 2 at% bis 3 at% umfasst.

5. Beschichtetes Substrat nach einem der vorhergehenden Ansprüche,
wobei die mindestens eine dielektrische Schicht Teil der ersten dielektrischen Schicht (152) unterhalb der Funktionsschicht (146) und/oder einer zweiten dielektrischen Schicht (154) oberhalb der Funktionsschicht (146) ist.

6. Beschichtetes Substrat nach einem der vorhergehenden Ansprüche,
wobei sich die Funktionsschicht (146) zwischen zwei Oxid- (148) und/oder Metallschichten (150) in unmittelbarem Kontakt mit der Funktionsschicht (146) befindet.

7. Beschichtetes Substrat nach einem der vorhergehenden Ansprüche,
wobei das Substrat einer Wärmebehandlung standhält.

8. Beschichtetes Substrat nach einem der vorhergehenden Ansprüche,
wobei das Substrat mindestens eines der folgenden umfasst: Tafelglas, Architekturglas, Sicherheitsglas, entspiegeltes Glas, Glas für Solarpanele, Glas für Anwendungen im Automobilbereich.

9. Verfahren zur Herstellung eines beschichteten transparenten Substrats (104, 142) wie z.B. eines Glassubstrats, das mit einem temperaturbeständigen Beschichtungssystem (102, 144) beschichtet ist,
wobei das Beschichtungssystem (102, 144) eine Funktionsschicht (106, 146) mit Reflexionseigenschaften im Infrarot- und/oder Solarstrahlungsbereich, insbesondere eine Metallfunktionsschicht, die Silber oder eine silberhaltige Metalllegierung enthält, und mindestens eine, einen dielektrischen Stoff enthaltende, dielektrische Schicht (108, 152, 154) umfasst,
wobei sich die mindestens eine dielektrische Schicht (108, 152, 154) nicht in unmittelbarem Kontakt mit der Funktionsschicht (106, 146) befindet,
wobei die mindestens eine dielektrische Schicht (108, 152, 154) eine geometrische Dicke von 5 Nanometer oder mehr aufweist,
wobei die mindestens eine dielektrische Schicht (108, 152, 154) Titanoxid TiOₓ (114, 119) sowie einen Hafnium Hf enthaltenden Dotierstoff (122, 124) umfasst, und wobei das Verfahren die Durchführung eines Zerstäubungsprozesses (202, 204) zum Beschichten des Substrats (104) mit mindestens einer der Funktionsschicht und der dielektrischen Schicht umfasst.

10. Verfahren nach Anspruch 9, mit
dem Durchführen des Zerstäubungsprozesses an oder nahe einem Übergangspunkt von einem metallischen Zustand in einen oxidischen Zustand eines Zerstäubungsobjektes.

11. Verfahren nach Anspruch 9 oder 10, mit
dem Vergüten des mit dem Beschichtungssystem beschichteten Substrats bei einer Temperatur von 250°C oder mehr und/oder einer Temperatur von 500°C oder mehr und/oder einer Temperatur von 650°C oder mehr.

12. Verfahren zum Analysieren des Substrats nach einem der Ansprüche 1 bis 8, mit dem
Durchführen (284) einer ersten Trübungsmessung des beschichteten Substrats vor einem Vergütungsprozess;
Durchführen (286) eines oder mehrerer Vergütungsprozesse; sowie Durchführen (288) einer zweiten Trübungsmessung des beschichteten
Substrats nach einem Vergütungsprozess, wobei die Trübung gemäß der zweiten Messung gegenüber der Trübung gemäß der ersten Messung um weniger als einen Faktor 4, vorzugsweise weniger als einen Faktor 3, weiter bevorzugt weniger als einen Faktor 2 erhöht ist.

13. Verfahren nach Anspruch 12,
wobei die Trübung bei Reflexion gemessen wird.

## Revendications

1. Substrat transparent revêtu (104, 142), tel qu'un substrat de verre, revêtu d'un système de revêtement thermiquement résistant (102, 144),
dans lequel le système de revêtement (102, 144) comporte une couche fonctionnelle (106, 146) ayant des propriétés de réflexion dans la plage de rayonnement infrarouge et/ou solaire, en particulier une couche fonctionnelle métallique comportant de l'argent ou un alliage métallique contenant de l'argent, et au moins une couche diélectrique (108, 152, 154) comportant un matériau diélectrique,
dans lequel la au moins une couche diélectrique (108, 152, 154) n'est pas en contact direct avec la couche fonctionnelle (106, 146),
dans lequel la au moins une couche diélectrique (108, 152, 154) a une épaisseur géométrique de 5 nanomètres ou plus,
et dans lequel la au moins une couche diélectrique (108, 152, 154) comporte un oxyde de titane TiOₓ (114, 119) et un matériau dopant (122, 124) comportant du hafnium Hf.

2. Substrat revêtu selon la revendication 1,
dans lequel la couche diélectrique (108, 152, 154) a une épaisseur géométrique de 8 nanomètres ou plus, de préférence de 10 nanomètres ou plus.

3. Substrat revêtu selon la revendication 1 ou 2,
dans lequel la couche diélectrique (108, 152, 154) a une épaisseur géométrique de 100 nanomètres ou moins, de manière préférée de 80 nanomètres ou moins, de manière plus préférée de 50 nanomètres ou moins, de manière la plus préférée de 40 nanomètres ou moins.

4. Substrat revêtu selon l'une quelconque des revendications précédentes,
dans lequel la couche diélectrique (108, 152, 154) comporte une fraction de matériau dopant dans la plage de 0,2 % en atomes à 50 % en atomes, de préférence de 0,4 % en atomes à 30 % en atomes, de manière plus préférée de 0,6 % en atomes à 20 % en atomes, de manière encore plus préférée de 0,8 % en atomes à 10 % en atomes, de manière encore plus préférée de 1 % en atomes à 4 % en atomes, de manière la plus préférée de 2 % en atomes à 3 % en atomes.

5. Substrat revêtu selon l'une quelconque des revendications précédentes,
dans lequel la au moins une couche diélectrique est une partie d'une première couche diélectrique (152) sous la couche fonctionnelle (146) et/ou d'une seconde couche diélectrique (154) au-dessus de la couche fonctionnelle (146).

6. Substrat revêtu selon l'une quelconque des revendications précédentes,
dans lequel la couche fonctionnelle (146) se situe entre deux couches d'oxyde (148) et/ou de métal (150) en contact direct avec la couche fonctionnelle (146).

7. Substrat revêtu selon l'une quelconque des revendications précédentes,
dans lequel le substrat résiste à un traitement thermique.

8. Substrat revêtu selon l'une quelconque des revendications précédentes,
dans lequel le substrat comporte au moins un élément parmi du verre en feuille, du verre architectural, du verre de sécurité, du verre anti-réfléchissant, du verre pour des panneaux solaires, du verre pour des applications automobiles.

9. Procédé de fabrication d'un substrat transparent revêtu (104, 142), tel qu'un substrat de verre, revêtu d'un système de revêtement thermiquement résistant (102, 144),
dans lequel le système de revêtement (102, 144) comporte une couche fonctionnelle (106, 146) ayant des propriétés de réflexion dans la plage de rayonnement infrarouge et/ou solaire, en particulier une couche fonctionnelle métallique comportant de l'argent ou un alliage métallique contenant de l'argent, et au moins une couche diélectrique (108, 152, 154) comportant un matériau diélectrique,
dans lequel la au moins une couche diélectrique (108, 152, 154) n'est pas en contact direct avec la couche fonctionnelle (106, 146),
dans lequel la au moins une couche diélectrique (108, 152, 154) a une épaisseur géométrique de 5 nanomètres ou plus, dans lequel la au moins une couche diélectrique (108, 152, 154) comporte un oxyde de titane TiOₓ (114, 119) et un matériau dopant (122, 124) comportant du hafnium Hf, et dans lequel le procédé comporte la mise en oeuvre d'un processus de pulvérisation (202, 204) pour revêtir le substrat (104) d'au moins une couche parmi la couche fonctionnelle et la couche diélectrique.

10. Procédé selon la revendication 9, comportant la mise en oeuvre du processus de pulvérisation sur ou près d'un point de transition d'un état métallique à un état oxydé d'une cible de pulvérisation.

11. Procédé selon la revendication 9 ou 10, comportant l'étape consistant à soumettre le substrat revêtu du système de revêtement à une température de 250 °C ou plus, et/ou à une température de 500 °C ou plus, et/ou à une température de 650 °C ou plus.

12. Procédé d'analyse du substrat selon l'une quelconque des revendications 1 à 8, comportant les étapes consistant à :
effectuer (284) une première mesure de trouble du substrat revêtu avant tout processus de revenu ;
mettre en oeuvre (286) un ou plusieurs processus de revenu ; et effectuer (288) une seconde mesure de trouble du substrat revêtu après tout processus de revenu, dans lequel le trouble selon la seconde mesure comparé au trouble selon la première mesure est augmenté de moins d'un facteur de 4, de préférence de moins d'un facteur de 3, de manière plus préférée de moins d'un facteur de 2.

13. Procédé selon la revendication 12,
dans lequel le trouble est mesuré en réflexion.
